# EUROPÄISCHE PATENTANMELDUNG

(11) **EP 4 679 038 A2**
(43) Veröffentlichungstag der Anmeldung: **14.01.2026**
(21) Anmeldenummer: 25213806.0
(22) Anmeldetag: 23.12.2022
(51) Int. Cl.: G01D 5/24

(54) **SENSORANORDNUNG UND VERFAHREN ZUR ERFASSUNG EINES VERHALTENS EINES FAHRZEUGBENUTZERS IM FAHRGASTRAUM EINES KRAFTFAHRZEUGES**

(30) Priorität: 24.12.2021 DE 102021006344
(62) Teilanmeldung aus: 22843823.0
(71) Anmelder: Gentherm GmbH, 85235 Odelzhausen (DE)
(72) Erfinder: Péter, Márton, 2011 Budakalász (HU)
(74) Vertreter: Benninger, Johannes

(57) **Zusammenfassung**

Die Erfindung betrifft eine Schaltung für eine Sensoranordnung zur Unterdrückung oder Eliminierung von internen Kapazitäten eines Leistungs-MOSFETS wenn ein Signal mit niederpegeligen Wechselstrom Messsignal auf die Energieversorgung für die elektrischen Heizelemente aufgeschaltet ist, umfassend
- eine Energieversorgung (Vbat) für elektrische Heizelemente im Lenkrad (34), umfassend einen Heizwiderstand (Heater resistor),
- MOSFET T1 und T2, wobei T1 und T2 jeweils vom n-Typ sind,
- MOSFET T3 und T4, wobei T3 und T4 jeweils vom p-Typ sind,
- einen Masseanschluss (GND),
- eine Heizkapazität (Heating capacitance),
- einen Entkopplungs-Kondensator (C1),
- Kondensatoren (C2 und C3),
- einen Operationsverstärker (U1), und
- ein niederpegeliges Wechselstrom-Messsignal (AC measurement signal),
wobei die Energieversorgung für die elektrischen Heizelemente des Lenkrades (34) mittels der MOSFET T1 und T2 und MOSFET T3 und T4 verschaltet sind, und wobei MOSFET T1 und T2 den Heizwiderstand (Heater resistance) im Lenkrad (34) auf Masse schalten und MOSFET T3 und T4 den Heizwiderstand (Heater resistance) mit der Stromversorgung (Vbat) verbinden.

## Beschreibung

Die vorliegende Erfindung betrifft eine Sensoranordnung für den Fahrgastraum in einem Kraftfahrzeug mit einer elektrischen Schaltung. Die Erfindung betrifft außerdem ein Verfahren zur Erfassung eines Verhaltens oder einer Sitzposition eines im Fahrgastraum eines Kraftfahrzeuges befindlichen Fahrzeugbenutzers oder Fahrzeuglenkers.

Moderne Kraftfahrzeuge sind mit einer Vielzahl von Komforteinrichtungen im Innenraum ausgestattet, so unter anderem mit einer Sitzheizung sowie häufig auch mit einer Lenkradheizung. Weitere Heizelemente können vorhanden sein, deren Heizwirkung auf unterschiedlichen physikalischen Effekten beruhen kann.

Im Interesse einer Aufrechterhaltung eines hohen Sicherheitsniveaus ist es insbesondere im Hinblick der sich abzeichnenden Entwicklung von sich autonom und teilautonom durch den Verkehr bewegenden Kraftfahrzeugen wünschenswert, das Verhalten des Fahrers im Fahrzeug während der Fahrt erkennen und ggf. auch unmittelbar oder zumindest ohne nennenswerte zeitliche Verzögerung beeinflussen zu können. Außerdem kann es wünschenswert oder notwendig sein, das Verhalten des Fahrers auszuwerten, damit in Abhängigkeit davon unterschiedliche Steuerungsfunktionen im Fahrzeug ausgelöst oder beeinflusst werden können.

Hierfür stehen grundsätzlich zahlreiche Sensoren zur Verfügung, die bspw. erfassen können, ob sich der Fahrer aktuell mit dem Verkehrsgeschehen beschäftigt oder ob er möglicherweise stark abgelenkt ist. Weitere Sensoren sind in der Lage, die Hand- und Kopfhaltung zu erfassen, um auf diese Weise sicherzustellen, ob der Fahrer seine Hände am Lenkrad hat oder nicht.

Alle diese Sensoreinrichtungen sind aufwendig und verursachen Kosten. Zudem benötigen sie jeweils relativ hohe Rechenleistungen zur parallelen Verarbeitung aller benötigten Sensorsignale.

Aus diesem Grund wäre es wünschenswert, einfachere Sensoren mit geringerem Rechenaufwand, der für die Verarbeitung der Sensorsignale notwendig ist, einsetzen zu können, um zu den gewünschten Informationen zu gelangen.

Im Idealfall können sogar vorhandene Komforteinrichtungen als Sensoren eingesetzt werden.

Es kann deshalb als ein vorrangiges Ziel der vorliegenden Erfindung betrachtet werden, eine vereinfachte Sensorik zur Erfassung eines Verhaltens und/oder einer Hand- oder Körperhaltung eines Fahrzeugbenutzers oder Fahrzeuglenkers eines Kraftfahrzeuges zur Verfügung zu stellen, wobei die Sensorik vorzugsweise vorhandene Komponenten nutzen kann, die normalerweise anderen Zwecken dienen.

Dieses Ziel der Erfindung wird mit dem Gegenstand des unabhängigen Anspruchs erreicht. Merkmale vorteilhafter Weiterbildungen der Erfindung finden sich in den abhängigen Ansprüchen.

So schlägt die Erfindung zur Erreichung des genannten Ziels eine Schaltung für eine Sensoranordnung eines Fahrgastraums in einem Kraftfahrzeug oder für eine Nutzung in einem Kraftfahrzeug vor.

Die Erfindung betrifft eine Schaltung zur Unterdrückung oder Eliminierung von internen Kapazitäten eines Leistungs-MOSFETS wenn ein Signal mit niederpegeligen Wechselstrom Messsignal auf die Energieversorgung für die elektrischen Heizelemente aufgeschaltet ist.

Gegenstand der vorliegenden Erfindung ist eine Schaltung zur Unterdrückung oder Eliminierung von internen Kapazitäten eines Leistungs-MOSFET (Metall-Oxid-Halbleiter-Feldeffekttransistor), wenn ein Signal mit geringem Pegel auf einer Stromversorgungsleitung aufgeschaltet ist.

Als Schalter eingesetzte Leistungs-MOSFET bilden im geöffneten Zustand generell relativ hohe interne Kapazitäten zwischen dem Drain-Anschluss und dem Source-Anschluss aus, was im Wesentlichen an ihrer integrierten Diode liegt. Daraus folgt, dass diese Kapazität ungefähr umgekehrt proportional ist zu der zwischen dem Drain-Anschluss und dem Source-Anschluss anliegenden Spannung. Da sich diese Spannung verändern kann, ist es auch nicht möglich, einen festen Wert für die interne Kapazität anzugeben. Hinzu kommt, dass die interne Kapazität aus fertigungstechnischen Gründen unterschiedlich ausfallen kann, da verschiedene Chargen von hergestellten MOSFET jeweils leicht unterschiedliche Eigenschaften aufweisen können, so dass auch die Kapazitätswerte normalerweise streuen.

Da jedoch für manche Einsatzzwecke der Leistungs-MOSFET wie insbesondere den erwähnten Zweck, als Schaltelement zur Überlagerung von niedrigpegeligen Spannungen auf höhere Versorgungsspannungen zu dienen, diese internen Kapazitäten störende Einflüsse entwickeln können, wird mittels der erfindungsgemäßen Schaltung versucht, diese negativen Einflüsse zu reduzieren oder zu eliminieren. Dies bietet den Vorteil, stabilere Kapazitätsmessewerte zu erzielen.

Die elektrische Schaltung kann Bestandteil einer Detektionseinrichtung sein, die erkennen soll, ob ein Fahrzeuglenker seine Hände am Lenkrad liegen oder von diesem entfernt hat. Die Energieversorgung für die elektrischen Heizelemente des Lenkrades sollen dabei mittels zweier unterer MOSFETs T1 und T2, die jeweils vom n-Typ sind, und mittels zweier oberer MOSFETs T3 und T4, die jeweils vom p-Typ sind, geschaltet werden.

Hierbei sind die beiden n-Typ MOSFETs T1 und T2 in einer Weise verschaltet, dass sie den Heizwiderstand (Heater resistor) im Lenkrad auf Masse schalten. Zudem sind die beiden p-Typ MOSFETs T3 und T4 in einer Weise verschaltet, dass sie den Heizwiderstand mit der Stromversorgung (power supply) verbinden können. Die unterhalb des Heizwiderstandes vorgesehene Heizkapazität (Heater Capacitance) verdeutlicht die sich im Heizbetrieb einstellende Kapazität des Heizwiderstandes gegen den Masseanschluss (GND).

Bei geöffneten MOSFETs ist das niederpegelige Wechselstrom-Messsignal (AC measurement signal) über einen Entkoppelungs-Kondensator mit dem Heizwiderstand verbunden. Dieser Entkoppelungs-Kondensator weist einen weitaus höheren Kapazitätswert auf als die Kapazität des Heizwiderstandes, um auf diese Weise einen Verlust an Signalstärke zu vermeiden.

Der Operationsverstärker (unity gain amplifier), der das Signal mit dem Faktor "Eins" verstärkt und aufbereitet, sorgt dafür, das niederpegelige Wechselstrom-Messsignal (AC measurement signal) am Verbindungskontakt des MOSFET-Paares mit gleicher Phase und gleicher Amplitude einzuspeisen. Damit wird sichergestellt, dass die geöffneten MOSFET-Schalter noch nicht mit der Signalquelle beaufschlagt werden und solchermaßen die Messung beeinflussen können.

Zwei Kondensatoren bilden jeweils Entkoppelungs-Kapazitäten und sorgen für eine Trennung unterschiedlicher Pegelspannungen der Gleichstromversorgung.

Da an den MOSFET T2 und T3 jeweils dasselbe Wechselspannungssignal an ihren Source- wie auch an ihren Drain-Anschlüssen anliegt, fließt durch T2 und T3 jeweils keine Wechselspannung, was auch dafür sorgt, dass die interne parasitäre Kapazität von T2 und T3 nicht die geschalteten Verbindungsleitungen erreicht.

Durch Messung der Amplitude und der Phase der Spannung und des Stroms des Messsignals ist es möglich, den Wert der Kapazität des Heizwiderstandes (Heater Capacitance of the Heater resistor) zu berechnen, was wiederum die gewünschten Informationen über den Berührstatus der Hände des Fahrzeuglenkers auf dem Lenkrad liefern kann.

Darüber hinaus wären N-Kanal-MOSFETs ebenso als oberseitige Schalter verwendbar, womit eine Gate-Treiber-Schaltung realisierbar wäre.

Weiterhin wird eine Sensoranordnung für den Fahrgastraum in einem Kraftfahrzeug oder für eine Nutzung in einem Kraftfahrzeug beschrieben, wobei diese Sensoranordnung zumindest die nachfolgend genannten und in ihren Funktionen sowie in ihrer Zusammenwirkung erläuterten Komponenten umfasst. So umfasst die Sensoranordnung mindestens ein Referenz-Objekt, mindestens eine Referenz-Elektrode im Bereich des Referenz-Objektes, mindestens eine beabstandet zum Referenz-Objekt angeordnete Berühr-Oberfläche sowie mindestens eine im Bereich der Berühr-Oberfläche angeordnete Berühr-Elektrode.

Die Anwendung der Sensoranordnung sieht vor, dass die Referenz-Elektrode und die Berühr-Elektrode mittels eines Feldes elektrisch zusammenwirken. Ein Fahrzeugbenutzer kann durch Berühren der Berühr-Oberfläche oder bereits durch eine Annäherung an die Berühr-Oberfläche mindestens einen physikalischen Parameter des Feldes beeinflussen.

Wenn an dieser Stelle sowie im Zusammenhang mit der Sensoranordnung ganz allgemein von einem Feld die Rede ist, so kann damit insbesondere ein elektrisches Feld, ein magnetisches Feld oder ein elektromagnetisches Feld gemeint sein.

Weiterhin sieht die solchermaßen definierte Sensoranordnung vor, dass mindestens einer dieser physikalischen Parameter entweder eine Kapazität, eine elektrische Induktivität oder eine Kombination einer überlagerten Kapazität und Induktivität ist.

So kann im Falle einer den mindestens einen physikalischen Parameter bildenden Kapazität ein elektrischer Kondensator ausgebildet sein, welcher durch die Referenz-Elektrode und durch die Berühr-Elektrode gebildet bzw. zwischen diesen beiden Elektroden ausgebildet ist.

Wahlweise kann auch im Falle einer den mindestens einen physikalischen Parameter bildenden elektrischen Induktivität eine Spule oder ein anderes induktiv wirkendes Bauteil ausgebildet sein, wobei dieses Bauteil eine zwischen der Referenz-Elektrode und der Berühr-Elektrode ausgebildete oder wirkende Bauteil-Induktivität hat.

Wenn im vorliegenden Zusammenhang von einer elektrischen Induktivität oder von einer zwischen der Referenz-Elektrode und der Berühr-Elektrode ausgebildeten Bauteil-Induktivität gesprochen wird, so ist damit in aller Regel ein passives elektrisches Bauteil gemeint, das einer Induktivität entspricht oder eine elektrische Induktivität ausbildet, wobei diese Induktivität veränderlich sein kann. Eine veränderliche Induktivität kann sich insbesondere aus Aktivitäten, Bewegungen oder Positionsveränderungen des Fahrzeugbenutzers ergeben, etwa wenn dieser die Berühr-Oberfläche kontaktiert oder sich dieser annähert.

Bei der Sensoranordnung kann die Bauteilinduktivität der elektrischen Induktivität insbesondere durch eine elektrische Spule oder durch eine als elektrische Spule fungierende oder wie eine elektrische Spule wirkende Anordnung gebildet sein.

Weiterhin ist es jedoch auch denkbar, dass das zwischen der Referenz-Elektrode und der damit elektrisch zusammenwirkenden Berühr-Elektrode ausgebildete Feld sowohl durch eine Kapazität als auch durch eine diese Kapazität überlagernde Induktivität beeinflusst werden kann, welche Kapazität und Induktivität jeweils aus einer Wechselwirkung der Referenz-Elektrode und der Berühr-Elektrode gebildet sein können. Das Zusammenwirken der beiden Elektroden kann somit induktiv, kapazitiv oder sowohl induktiv als auch kapazitiv erfolgen.

Wenn im Zusammenhang mit der Wirkungsweise der Sensoranordnung davon gesprochen wird, dass ein Fahrzeugbenutzer durch Berühren der Berühr-Oberfläche mindestens einen physikalischen Parameter des oben erläuterten Feldes zwischen den elektrisch zusammenwirkenden Referenz- und Berühr-Elektroden beeinflussen kann, so können damit verschiedene physikalische Effekte gemeint bzw. von der Berührung durch den Fahrzeugbenutzer betroffen sein.

So kann der Körper des Fahrzeugbenutzers oder ein zwischen den Referenz- und Berühr-Elektroden befindliches Körperteil des Fahrzeugbenutzers den Kapazitätswert des Kondensators ändern, der durch die Referenz- und Berühr-Elektrode ausgebildet sein kann, etwa durch Veränderung des durch den Körper oder das Körperteil beeinflussten Dielektrikums oder auch durch Veränderung oder Beeinflussung der effektiven Elektrodenflächen durch die Berührung der Berühr-Oberfläche.

Weitere physikalische Effekte im Zusammenhang mit der Beeinflussung der durch Berührung der Berühr-Oberfläche veränderten oder beeinflussten Kapazität können auf der Beeinflussung des zwischen den Referenz- und Berühr-Elektroden aufgebauten Feldes beruhen, etwa durch ein Verschieben von elektrischer Ladung durch elektrische Induktion, ohne dass dabei eine der Elektroden unmittelbar berührt werden muss. Ein weiterer Effekt kann bspw. durch die Speicherung und/oder Übertragung von elektrischer Energie oder Feldenergie mittels der insbesondere veränderlichen Kapazität des Feldes dargestellt sein.

Wahlweise kann der Körper des Fahrzeugbenutzers oder ein zwischen den Referenz- und Berühr-Elektroden befindliches Körperteil des Fahrzeugbenutzers den elektrischen Induktionswert der Bauteil-Induktivität ändern, die durch die Referenz- und Berühr-Elektrode oder zwischen den beiden Elektroden ausgebildet sein kann, etwa durch Veränderung des durch den Körper oder das Körperteil beeinflussten Spulenkerns oder auch durch Veränderung oder Beeinflussung der Spulenkomponenten oder effektiven Spulenflächen durch die Berührung der Berühr-Oberfläche.

Weitere physikalische Effekte im Zusammenhang mit der Beeinflussung der durch Berührung der Berühr-Oberfläche veränderten oder beeinflussten Induktivität können auf der Beeinflussung des zwischen den Referenz- und Berühr-Elektroden aufgebauten Feldes beruhen, etwa durch ein Verschieben von elektrischer Ladung durch elektrische Induktion, ohne dass dabei eine der Elektroden unmittelbar berührt werden muss. Ein weiterer Effekt kann bspw. auf einer Speicherung und/oder Übertragung von elektrischer Energie oder Feldenergie mittels der insbesondere veränderlichen Induktivität des Feldes beruhen.

Wie oben erwähnt, können die sensorischen Effekte wahlweise auch durch eine Kombination der genannten feldbeeinflussenden Parameter erfolgen, nämlich durch eine Überlagerung einer zwischen der Referenz- und Berührelektroden zu erfassenden Kapazität mit einer zwischen der Referenz- und Berührelektroden zu erfassenden Induktivität.

Es sei an dieser Stelle ausdrücklich betont, dass alle hier beschriebenen Varianten, bei denen sich die Feldparameter durch Berührung der Berühr-Oberfläche verändern oder beeinflussen lassen, gleichermaßen für eine Annäherung an die Berühr-Oberfläche gelten können. So kann wahlweise bereits eine Annäherung des Fahrzeugbenutzers an die Berühr-Oberfläche oder die Unterschreitung eines definierbaren Mindestabstandes zwischen dem Fahrzeugbenutzer und der Berühr-Oberfläche den mittels der Sensoranordnung zu erfassenden physikalischen Effekt auslösen, wobei dieser Mindestabstand vorzugsweise sinnvolle Werte von wenigen Zentimetern oder wenigen Millimetern annehmen kann, die in einem Fahrzeuginnenraum oder Fahrgastraum zu praktisch anwendbaren Sensorkonfigurationen führen können. Da es sich bei den hier verwendeten Sensorkonfigurationen um veränderliche Induktivitäten und/oder veränderliche Kapazitäten handelt, deren Werte erfasst werden sollen, können gleichermaßen Annäherungen des Fahrzeugbenutzers an die Berühr-Oberfläche genutzt werden, ohne dass eine unmittelbare Kontaktierung erfolgen muss.

Mit dem hier verwendeten Begriff der Annäherung an die oder Berührung der Berühr-Oberfläche ist generell gemeint, dass sich der Fahrzeugbenutzer an die Berühroberfläche annähert oder diese kontaktiert, wobei er dies mit seinem Körper oder mit einem Körperteil tun kann, etwa mit seiner Hand.

Zudem sei darauf hingewiesen, dass der hier verwendete Begriff des Fahrzeugbenutzers jeden Fahrer oder Passagier im Fahrgastraum des Kraftfahrzeuges umfassen kann, der sich dort aktuell bzw. im Zusammenhang mit dem Einsatz der Sensoranordnung aufhält und in feldbeeinflussender Weise mit der Sensoranordnung wechselwirken kann. Somit kann der hier verwendete Begriff des Fahrzeugbenutzers auch mehrere Personen umfassen, wobei es definitionsgemäß genügt, wenn nur eine dieser mehreren Personen in eine feldbeeinflussende Wechselwirkung mit der Sensoranordnung eintritt, wogegen zu einem anderen Zeitpunkt eine weitere Personen in feldbeeinflussende Wechselwirkung mit der Sensoranordnung geraten kann.

Da weiter unten weitere Ausstattungsoptionen der Sensoranordnung genannt werden, die im Zusammenhang mit einer als Option zu sehenden beheizbaren oder beheizten Berühr-Oberfläche stehen, sei hier ergänzend klargestellt, dass der Begriff des Fahrzeugbenutzers weit zu verstehen ist und nicht nur menschliche Fahrzeuginsassen umfassen soll, sondern auch Tiere, die ggf. als Passiere im Fahrgastraum befördert werden und sich innerhalb des Fahrgastraumes und somit im Wirkungsbereich der Sensoranordnung aufhalten. Somit sei klargestellt, dass unter Umständen auch ein tierischer Passagier wie etwa ein Haustier feldbeeinflussende Kontaktierungen oder Annäherungen der Berühr-Oberfläche unternehmen kann, die mittels der Sensoranordnung erfasst werden können.

Bei der Sensoranordnung kann das Referenz-Objekt durch ein Einrichtungs- oder Möblierungselement des Fahrgastraumes und/oder durch ein Bedien- oder Betätigungselement innerhalb des Fahrgastraumes oder durch eine Unterbaugruppe der genannten Elemente gebildet sein. So kann das Referenz-Objekt z.B. durch ein Sitzgestell oder durch einen Teil des Sitzgestells für den Fahrzeugbenutzer bzw. für einen der Fahrzeugbenutzer gebildet sein. Insbesondere können leitfähige Bestandteile des Sitzgestells das Referenz-Objekt bilden.

Das Referenz-Objekt kann wahlweise auch durch das Dach des Fahrgastraumes oder durch Dachabschnitte gebildet sein, d.h. durch Bereiche des Fahrgastraumes, die sich oberhalb von Fensterflächen des Kraftfahrzeuges befinden.

Wahlweise kann das Referenz-Objekt durch eine Tür oder durch Abschnitte der Tür, bspw. durch Teile oder Teilbereiche einer Türinnenverkleidung o. dgl. gebildet sein.

Weiterhin kann das Referenz-Objekt wahlweise auch durch ein Armaturen- oder Instrumentenbrett oder durch Abschnitte des Instrumentenbretts gebildet sein. Mit dem Begriff des Armaturen- oder Instrumentenbretts sind insbesondere diejenigen Bereiche des Fahrgastraumes des Kraftfahrzeuges gemeint, die sich unterhalb oder im Bereich einer Frontscheibe befinden, durch welche der Fahrzeugführer, d.h. der für die Führung des Kraftfahrzeuges im Verkehr verantwortliche Fahrzeugbenutzer, beim Führen und Lenken des Kraftfahrzeuges vorrangig das Verkehrsgeschehen beobachtet.

Ebenso kann das Referenz-Objekt durch ein Lenkrad oder durch ein anderes für die Umsetzung von Lenkbefehlen des lenkenden Fahrzeugbenutzers, d.h. des Fahrzeugführers, geeignetes Lenkinstrument gebildet sein. Dabei kann das Referenz-Objekt insbesondere durch leitfähige Bestandteile oder Unterbaugruppen des Lenkrades oder anderen Lenkinstruments gebildet sein.

Das hier so bezeichnete Referenz-Objekt kann darüber hinaus auch mehrere der genannten Elemente umfassen und gleichsam dezentral über mehrere der genannten Elemente verteilt sein, die gemeinsam das Referenz-Objekt bilden. So kann das Referenz-Objekt bspw. auf mehrere Sitzgestelle und/oder auf einen Ort oder Bereich im Armaturenbrett und/oder das Lenkrad und/oder andere Bereiche des Fahrgastraumes etc. verteilt sein.

Bei einer weiteren Ausführungsvariante der Sensoranordnung kann die beabstandet zum Referenz-Objekt angeordnete und im Fahrgastraum befindliche Berühr-Oberfläche eine vom Fahrzeugbenutzer kontaktierbare oder durch Berührungen erreichbare Oberfläche innerhalb des Fahrgastraumes sein. Damit kann insbesondere jede Fläche gemeint sein, mit der der Fahrzeugbenutzer oder einer von mehreren Fahrzeugbenutzern in Kontakt kommen oder treten kann.

Somit kann die Berühr-Oberfläche insbesondere wenigstens ein Einrichtungs- oder Möblierungselement des Fahrgastraumes und/oder ein Bedien- oder Betätigungselement innerhalb des Fahrgastraumes oder eine Unterbaugruppe der genannten Elemente zumindest teilweise bedecken oder umhüllen, womit solche Bereiche innerhalb des Fahrgastraumes als Berühr-Oberflächen in Frage kommen, die vom Fahrzeugbenutzer oder von den Fahrzeugbenutzern erreicht und kontaktiert werden können, wenn er sich im Fahrgastraum aufhält oder wenn sich die mehreren Fahrzeugbenutzer im Fahrgastraum aufhalten.

Insbesondere kann der Begriff der Berühr-Oberfläche solche Flächen oder Oberflächen umfassen, die einem Fahrzeugbenutzer oder Passagier des Kraftfahrzeuges unmittelbar zugänglich sind, ohne dass Demontagearbeiten irgendwelcher Art auszuführen sind. Damit sind solche Bereiche im Fahrgastraum vom Begriff der Berühr-Oberfläche in aller Regel nicht umfasst, bei denen vorher Demontagearbeiten notwendig sind, etwa durch Lösen von Schraubverbindungen oder sonstigen Verbindungen, für deren Lösen Werkzeuge einzusetzen sind.

Die Berühr-Oberfläche oder zumindest bestimmte Teilbereiche der Berühr-Oberfläche können wahlweise beheizt und/oder beheizbar sein. So kann die Berühr-Oberfläche z.B. mit einer Infrarot-Heizung wirkverbunden sein, wobei die Berühr-Oberfläche insbesondere mit einem Infrarot-Strahler ausgestattet ist. Grundsätzlich kann eine solche beheizte oder beheizbare Berühr-Oberfläche jeder der oben genannten Flächen oder Teilabschnitte dieser Flächen zugeordnet sein, also jede der genannten Flächen, die einem Fahrzeugbenutzer oder Passagier zugänglich oder von diesem erreichbar sind, etwa durch Kontaktierung mit seinem Körper oder durch Bewegungen oder das Ausstrecken einer Hand.

Grundsätzlich ist es auch denkbar, dass die als wahlweise beheizbar definierte Berühr-Oberfläche auf passive Weise beheizbar ist, etwa durch gezielte Bestrahlung einer wärmeemittierenden und/oder Wärmestrahlung reflektierenden Fläche, wobei die eigentliche Strahlungsquelle sich an anderer Stelle befindet, d.h. beabstandet von der Berühr-Oberfläche.

Als beheizte oder beheizbare Berühr-Oberfläche eignen sich im Wesentlichen alle diejenigen Flächen im Fahrgastraum, die mit einer wärmeemittierenden Fläche wie bspw. mit einem Infrarot-Strahler oder einer Infrarot-Heizung ausgestattet sein können, wobei diese Flächen insbesondere dem Innenraum des Fahrgastraumes zugewandt sind, in dem sich die Fahrzeugbenutzer oder Passagiere aufhalten, sei dies der Fußraum, der mittlere Bereich des Fahrgastraumes unterhalb einer Fensterfläche oder der Bereich oberhalb der Gürtellinie des Fahrzeuges, in dem sich die Köpfe der Fahrzeugbenutzer befinden.

Als solche Flächen, in denen Infrarot-Strahler angeordnet sein können, eignen sich bspw. Sitzauflagen, Sitzoberflächen, das Lenkrad, jegliche andere Betätigungselemente innerhalb des Fahrgastraumes wie etwa ein Schaltknüppel oder Schalthebel, der Dachhimmel, die Türinnenseiten bzw. Türinnenverkleidungen, das Armaturen- oder Instrumentenbrett, ggf. vorhandene Armauflagen für die Fahrzeugbenutzer, eine Fußraumverkleidung, Innenverkleidungsteile an den Fenstersäulen des Fahrzeuges, d.h. an der A-Säule, an der B-Säule und/oder an der C-Säule, leitfähige Bestandteile eines Sitzgestells und/oder eines Lenkrades etc.

Grundsätzlich können die mit einer beheizten oder beheizbaren Oberfläche wie bspw. mit einem Infrarot-Strahler ausgestatteten Berühr-Oberflächen oder Teilbereiche der Berühr-Oberflächen somit durch jedes vorhandene Einrichtungs- oder Möblierungselement des Fahrgastraumes und/oder durch jedes vorhandene Bedien- oder Betätigungselement innerhalb des Fahrgastraumes oder auch durch eine Unterbaugruppe der genannten Elemente gebildet sein, wobei solche Bereiche innerhalb des Fahrgastraumes als beheizte oder beheizbare Berühr-Oberflächen in Frage kommen, die vom Fahrzeugbenutzer oder von den Fahrzeugbenutzern erreicht und kontaktiert werden können, wenn er sich im Fahrgastraum aufhält.

Da solche beheizten oder beheizbaren Berühr-Oberflächen, wie sie hier beschrieben sind, insbesondere durch leistungsfähige Strahlungsheizungen innerhalb des Fahrgastraums realisiert sein können, sind geeignete Maßnahmen zu treffen, um die Fahrzeugbenutzer vor Beeinträchtigungen solcher Strahlungsheizungen zu schützen. Da die beheizten Oberflächen solcher Strahlungsheizungen auf Temperaturen von teilweise über 100°C aufgeheizt werden, um ein gewünschtes Ausmaß an Strahlungswärme erzeugen zu können, müssen die hohen Temperaturen möglichst verzögerungsfrei abgeschaltet werden, sobald sich ein Fahrzeugbenutzer einer dieser Heiz- und Heißzonen annähert oder die betreffende Berühr-Oberfläche kontaktiert. Dies gilt sowohl bei menschlichen als auch bei tierischen Fahrzeuginsassen, denn wie oben erwähnt, sind alle Fahrzeuginsassen vor Beeinträchtigungen durch die optional vorhandenen Strahlungsheizungen in ausreichendem Maße zu schützen.

Aus den genannten Gründen kann es deshalb besonders sinnvoll sein, zumindest diejenigen Bereiche im Fahrgastraum mit Komponenten der hierfür relevanten Sensorik der Sensoranordnung auszustatten, die mit solchen beheizten Flächen oder InfrarotStrahlern ausgestattet sind, so dass vorzugsweise jedem ggf. vorhandenen Heizelement oder Infrarot-Strahler eine in unmittelbarer räumlicher Nähe befindliche bzw. in der beheizbaren oder beheizten Berühr-Oberfläche integrierte Berühr-Elektrode zugeordnet ist. Da mehrere Heizelemente oder Infrarot-Strahler im Fahrgastraum verteilt sein können, muss zumindest die Oberflächentemperatur desjenigen Heizelements oder Infrarot-Strahlers verzögerungsfrei auf gesundheitlich unbedenkliche Werte reduziert werden können, dem sich der Fahrzeugbenutzer oder dem sich einer von mehreren Fahrzeugbenutzern nähert oder es kontaktiert.

Bei einer weiteren Ausführungsvariante der Sensoranordnung kann die Referenz-Elektrode zumindest teilweise durch das Referenz-Objekt gebildet sein. Wahlweise oder in Kombination dieser Ausführungsvariante kann die Referenz-Elektrode auch am Referenz-Objekt angeordnet sein. Wahlweise oder in Kombination mit einer der beiden zuvor genannten Ausführungsvarianten oder mit beiden genannten Ausführungsvarianten kann die Referenz-Elektrode auch zumindest teilweise im Referenz-Objekt integriert sein.

Eine solchermaßen ausgebildete Referenz-Elektrode kann dabei als erste Kondensatorelektrode eines Kondensators wirken oder kann eine erste Kondensatorelektrode des Kondensators bilden. Hierdurch kann sie ggf. in Wechselwirkung mit einer zweiten Kondensatorelektrode treten, insbesondere mit einer durch die Berühr-Elektrode gebildeten zweiten Kondensatorelektrode.

Darüber hinaus oder alternativ kann vorgesehen sein, dass eine solchermaßen ausgebildete Referenz-Elektrode mindestens eine ebene oder gewickelte elektrisch leitfähige Schicht aufweist.

Bei einer weiteren Ausführungsvariante der Sensoranordnung kann die Berühr-Elektrode zumindest teilweise durch die Berühr-Oberfläche gebildet und/oder zumindest teilweise in die Berühr-Oberfläche integriert sein.

Es kann auch vorgesehen sein, dass die Berühr-Elektrode zumindest teilweise an einer benutzerseitigen Seitenfläche der Berühr-Oberfläche angeordnet ist, d.h. an einer zum Fahrgastraum weisenden Seitenfläche der Berühr-Oberfläche, mit der ein Fahrzeugbenutzer oder Fahrzeuginsasse in Kontakt kommen kann, wenn er die Berühr-Oberfläche kontaktiert oder sich ihr nähert.

Alternativ hierzu kann auch vorgesehen sein, dass die Berühr-Elektrode zumindest teilweise an einer vom Benutzer abgewandten Seitenfläche der Berühr-Oberfläche angeordnet ist, d.h. an einer nicht zum Fahrgastraum weisenden Seitenfläche der Berühr-Oberfläche, so dass ein Fahrzeugbenutzer oder Fahrzeuginsasse mit einer solchermaßen ausgestatteten Berühr-Elektrode nicht in direkten Kontakt kommen kann, wenn er die Berühr-Oberfläche kontaktiert oder sich ihr nähert.

Eine solchermaßen ausgebildete Berühr-Elektrode kann dabei als zweite Kondensatorelektrode eines Kondensators wirken oder kann eine zweite Kondensatorelektrode des Kondensators bilden. Somit können die erste Kondensatorelektrode der Referenz-Elektrode und die zweite Kondensatorelektrode der Berühr-Elektrode wechselwirken und die beiden Elektroden eines hierdurch gebildeten Kondensators ausbilden.

Darüber hinaus oder alternativ kann vorgesehen sein, dass eine solchermaßen ausgebildete Berühr-Elektrode mindestens eine ebene oder gewickelte elektrisch leitfähige Schicht aufweist.

Wahlweise kann die Sensoranordnung auch in einer Weise ausgestaltet sein, dass sie in einem Kraftfahrzeug eingesetzt oder für eine Nutzung in einem Kraftfahrzeug verwendbar ist, wobei das Kraftfahrzeug mit mindestens einem Fahrzeugsitz für einen Fahrzeuglenker mit einem zumindest teilweise metallischen oder zumindest teilweise elektrisch leitfähigen Sitzgestell sowie mit einem in Fahrtrichtung vor dem Fahrzeugsitz befindlichen und vom Fahrzeugsitz beabstandeten Lenkrad ausgestattet sein kann.

Hierbei ist vorgesehen, dass das Lenkrad mit einer unterhalb einer Griffoberfläche und/oder dort integrierten flächigen oder gewickelten leitfähigen Schicht ausgestattet ist, die bspw. ein flaches Heizelement ausbilden kann, wie es seit einiger Zeit optional als elektrische Lenkradheizung eingesetzt wird. Eine solche elektrische Lenkradheizung basiert normalerweise auf dem Prinzip eines stromdurchflossenen elektrischen Widerstandes, der sich aufgrund des Stromflusses erwärmt, was als willkommener Heizeffekt für die lokale Erwärmung des vom Fahrzeuglenker mit seinen Händen umfassten Lenkradkranzes genutzt werden kann.

Ein solches Heizelement, wie es typischerweise als Lenkradheizung eingesetzt wird, kann bspw. einen flächigen Träger mit einem strangförmigen oder gewendelt verlaufenden Heizleiter oder mit mehreren strangförmigen oder gewendelten Heizleitern umfassen, wobei die Heizleiter insbesondere durch dünne Stahllitzen gebildet sein können, da diese auch bei sehr kleinen Querschnitten einen definierten elektrischem Widerstand und dabei eine relativ hohe Heizleistung liefern können. Diese bspw. durch dünne Stahllitzen gebildeten Heizleiter können zudem vorteilhafterweise auf einem Träger aufgebracht sein, der vorzugsweise durch ein Vlies oder Gewirke gebildet ist. Der Heizleiter kann bei insbesondere auf den durch das Vlies oder Gewirke gebildeten Träger aufgenäht sein.

Darüber oder umhüllend angeordnet befindet sich normalerweise die Deckschicht des Lenkrades, die als äußere Berührschicht oder Griffschicht vorzugsweise eine haptisch angenehme Oberfläche aufweist und deshalb insbesondere durch eine Lederschicht gebildet sein kann. Darüber hinaus werden Lenkräder in der Großserie häufig immer noch mit einer geschäumten Kunststoffschicht ausgestattet, was aber von vielen Nutzern weniger geschätzt wird als eine Lederschicht und deshalb insbesondere bei hochwertigerer Ausstattung und in Kombination mit einer Lenkradheizung nur in Ausnahmefällen zum Einsatz kommen wird. Im vorliegenden Zusammenhang ist es jedoch für die Funktionsweise der Sensoranordnung von untergeordneter Bedeutung, aus welchem Material die äußere Griffschicht des Lenkradkranzes besteht.

Für die Funktionsweise der hier erläuterten Ausführungsvariante der Sensoranordnung im Kraftfahrzeug ist es zudem erforderlich, dass das Sitzgestell, auf dem der Fahrzeuglenker sitzt, eine zumindest teilweise metallische und damit zumindest teilweise elektrisch leitfähige Schicht aufweist, die insbesondere durch ein metallisches oder teilweise aus Metall bestehendes Sitzgestell gebildet sein kann. Grundsätzlich können sich die leitfähigen Schichten jedoch auch im Sitzpolster, d.h. in der Sitzunterlage und/oder in der Sitzlehne befinden, so dass rein vorsorglich an dieser Stelle definiert sein soll, dass auch jegliche metallische und/oder leitfähige Schichten, die sich im Sitz- und/oder Lehnenpolster befinden und dort bspw. in Form von Rahmenteilen, von Federelementen und/oder von Sitzheizungsbestandteilen integriert sein können, als Sitzgestell im Sinne der Definition der vorliegenden verstanden werden sollen.

Auf diese Weise können das Sitzgestell und/oder die leitfähige Schicht des Lenkrads jeweils voneinander getrennte, aber induktiv und/oder kapazitiv zusammenwirkende Spulen- oder Kondensatoranschlüsse bilden, wodurch der auf dem Fahrzeugsitz befindliche und das Lenkrad mit seinen Händen umfassende Fahrzeuglenker eine messbare Kapazität und/oder Induktivität bildet, die zwischen den als Kondensator- oder Spulenanschlüssen wirkenden Sitzgestell und Lenkrad ausgebildet wird, wobei er diese Kapazität und/oder Induktivität durch seine Sitz- und Handhaltung messbar beeinflusst.

Dies wird bspw. dadurch erreicht, dass bei der Sensoranordnung die leitfähige Schicht des Lenkrades sowie das zumindest teilweise elektrisch leitfähige Sitzgestell zwei voneinander beabstandete Elektroden eines Kondensators ausbilden, so dass der auf dem Fahrzeugsitz befindliche und das Lenkrad mit seinen Händen umfassende Fahrzeuglenker ein zwischen den beabstandeten Elektroden des Kondensators befindliches und veränderliches Dielektrikum bildet, das die messbare Kapazität des Kondensators verändert.

Auf diese Weise kann die durch die Sitzposition und/oder Handhaltung des auf dem Fahrzeugsitz befindlichen Fahrzeuglenkers beeinflusste Kapazität aufgrund des vom Fahrer gebildeten und veränderlichen Dielektrikums des Kondensators gemessen und mittels einer Auswerteschaltung verarbeitet werden.

Um bspw. zu ermitteln, ob der Fahrzeuglenker die Hände am Lenkradkranz hat, können die Heizleiter des Heizelementes als flächiger Sensor fungieren, die als eine erste Kondensatorplatte an eine Mess- oder Auswerteschaltung angeschlossen werden kann. Außerdem kann diese erste Kondensatorplatte mit einer zweiten Zone, die z.B. durch das Sitzgestell, ein Polstergestell, das Sitzgestänge oder auch die Sitzheizung gebildet sein kann und die als zweite Kondensatorplatte fungiert, zusammengeschaltet werden, wodurch Änderungen der elektrischen Kapazität detektiert werden können, sobald der Fahrzeuglenker seine Hände ans Lenkrad legt oder von diesem entfernt.

Wahlweise kann bei der Sensoranordnung durch die leitfähige Schicht des Lenkrades eine erste Spule ausgebildet sein, wobei der auf dem Fahrzeugsitz befindliche und das Lenkrad mit seinen Händen umfassende Fahrzeuglenker einen mit der ersten Spule wechselwirkenden und veränderlichen Spulenkern bildet.

Ebenso denkbar ist es, dass zumindest das teilweise elektrisch leitfähige Sitzgestell eine zweite Spule ausbildet, wobei der auf dem Fahrzeugsitz befindliche Fahrzeuglenker einen mit der zweiten Spule wechselwirkenden und veränderlichen Spulenkern bildet.

In einer Kombination kann der auf dem Fahrzeugsitz befindliche und das Lenkrad mit seinen Händen umfassende Fahrzeuglenker zudem einen mit der ersten Spule wechselwirkenden und/oder einen mit der zweiten Spule wechselwirkenden und veränderlichen Spulenkern bilden.

Auch hier kann die durch die Sitzposition und/oder Handhaltung des auf dem Fahrzeugsitz befindlichen Fahrzeuglenkers beeinflusste Induktivität der ersten Spule und/oder die durch die Sitzposition des auf dem Fahrzeugsitz befindlichen Fahrzeuglenkers beeinflusste Induktivität der zweiten Spule gemessen und mittels einer Auswerteschaltung verarbeitet werden.

Um bei dieser Ausführungsvariante zu ermitteln, ob der Fahrzeuglenker die Hände am Lenkradkranz hat, können die Heizleiter des Heizelementes als elektrische Spule fungieren, die an eine Mess- oder Auswerteschaltung angeschlossen werden kann. Da die Hände des Fahrzeuglenkers einen veränderlichen Spulenkern bilden können, ist es möglich, eine sich verändernde Induktivität dieser Spule zu messen, sobald der Fahrzeuglenker seine Hände ans Lenkrad legt oder von diesem entfernt.

Außerdem kann wahlweise auch die zweite Zone, die z.B. durch das Sitzgestell, ein Polstergestell, das Sitzgestänge oder auch die Sitzheizung gebildet sein kann und die als zweite Spule fungieren kann, dazu genutzt werden, um durch Erfassung der veränderlichen Induktivität dieser Spule zu erkennen, ob sich der Fahrzeuglenker auf seinem Sitz befindet und/oder ob er die für die sichere Beherrschung des Fahrzeuges notwendige ordnungsgemäße Sitzposition einnimmt oder nicht.

Es können wahlweise die Berührungen des Lenkrades als unmittelbare Kapazitätsveränderung des Sensor-Elements oder auch als messbare Änderungen im Schwingungsverhalten des Systems gemessen werden. Um dies zu messen, wird auf das durch den stromdurchflossenen Leiter der Lenkradheizung und/oder durch den als Kondensatorplatte fungierenden Gegenpart im Sitzgestell gebildete Schwingungssystem ständig eine Frequenz bekannter Höhe aufgeprägt. Bei einer Berührung des Lenkrades ändert sich diese Frequenz. Da zudem das Ausmaß der Änderung von den Eigenschaften des berührenden Körpers abhängt, womit etwa seine Masse gemeint sein kann, und von der Art der Berührung, z.B. von der effektiven Kontaktfläche der Hände mit dem Lenkradkranz, abhängt, kann ein effektiv arbeitender Sensor zur Verfügung gestellt werden.

Dabei muss die Heizleistung stets ausreichend hoch sein und die Sensor-Funktion ausreichend genau. Außerdem ist es wichtig, dass sich der Heizbetrieb und der Sensorbetrieb gegenseitig nicht beeinflussen oder stören, und zwar unabhängig davon, ob aktuell ein Heizbedarf besteht oder nicht.

Somit ist es erforderlich, die durch die beschriebene Sensorik gebildete Messeinrichtung anzupassen an Betriebszustände mit hohem Stromdurchfluss durch das Heizelement, aber auch an Betriebszustände ohne Stromdurchfluss durch das Heizelement. Außerdem muss die Sensorik angepasst sein an weitgehend alle konstanten und variablen Einflüsse durch die Schaltungskomponenten selbst, was durch geeignete Kompensationseinrichtungen und/oder Kompensationsschaltungen berücksichtigt werden kann.

Wie aus dem zuvor Gesagten hervorgeht, benötigen sowohl Kondensatoren wie auch Spulen für eine Messung ihrer veränderten Werte, sei dies die veränderliche Kapazität beim Kondensator oder sei dies die veränderliche Induktivität bei der Spule, einen sie jeweils durchfließenden Wechselstrom, der aber normalerweise für eine Lenkradheizung nicht zur Verfügung steht. Da das normale Niederspannungs-Bordnetz in Kraftfahrzeugen einer Versorgung der elektrischen Komponenten mit Gleichstrom basiert, muss zur Realisierung der gewünschten Sensorik der Versorgungsspannung für die Lenkradheizung entweder ein hochfrequentes Wechselspannungssignal überlagert oder die Versorgungsspannung als Wechselstrom zur Verfügung gestellt werden. Beide Varianten sind grundsätzlich denkbar, wobei die erste Option zu bevorzugen sein dürfte. Es wird in der Praxis sinnvoller sein, die Gleichstromversorgung für die relativ leistungsstarke Stromversorgung der Lenkradheizung beizubehalten und dieser Stromversorgung ein hochfrequentes Signal niederer Spannung zu überlagern, was auch hinsichtlich der Signalauswertung günstiger sein dürfte, da sich auf diese Weise der Heizbetrieb und der Sensorbetrieb kaum oder gar nicht mehr gegenseitig stören.

Grundsätzlich können die beschriebenen Funktionen im Hinblick auf zukünftige Fahrzeugausstattungen von besonderer Bedeutung sein, da es bei automatisierten oder teilautomatisierten Fahrzeugsteuerungen notwendig sein kann, zu jedem Zeitpunkt und für jeden Fahrzustand erfassen zu können, ob der Fahrzeuglenker seine Hände am Lenkradkranz hat oder nicht. Zudem kann es wichtig sein zu erkennen, ob sich der Fahrzeuglenker auf seinem Sitz befindet und/oder ob er die für die sichere Beherrschung des Fahrzeuges notwendige ordnungsgemäße Sitzposition einnimmt oder nicht. Eine solche Auswertung kann bspw. sinnvoll sein, um das Steuerungssystem eine Entscheidung treffen zu lassen, ob das Fahrzeug bei sich anbahnenden kritischen Verkehrssituationen selbsttätig verzögert oder sogar zum Stillstand gebracht werden soll oder ob dem Fahrzeuglenker zuvor deutlich signalisiert werden soll, dass er die Steuerung übernehmen muss oder andernfalls mit einer Reduzierung der Fahrgeschwindigkeit rechnen muss, ggf. bis zum völligen Stillstand des Fahrzeuges.

Für die Auswertung von undefinierten Fahrzuständen oder für die Auswertung von Unregelmäßigkeiten oder von Unfällen solcher autonom oder teilautonom fahrender Kraftfahrzeuge kann es außerdem von hoher Bedeutung sein, nachträglich erfassen und nachvollziehen zu können, inwieweit der Fahrzeuglenker unmittelbar in die Steuerung des Fahrzeuges involviert war, denn es kann ausgewertet und protokolliert werden, ob er die Hände am Lenkrad hatte oder ob er möglicherweise sogar seinen Platz hinter dem Lenkrad verlassen hat.

Wie es weiter oben schon erläutert wurde, kann die Sensoranordnung auch in einer Weise ausgestaltet oder konfiguriert sein, dass der auf dem Fahrzeugsitz befindliche und das Lenkrad mit seinen Händen umfassende Fahrzeuglenker oder Fahrzeugbenutzer ein Feld beeinflusst, das zwischen den als Elektroden wirkenden leitfähigen Schichten des Sitzgestells und des Lenkrades ausgebildet wird. Zwischen den Elektroden kann zudem ein insbesondere veränderliches Feld ausgebildet sein.

Es sei an dieser Stelle zudem darauf hingewiesen, dass in einer Ausführungsvariante der Sensoranordnung vorgesehen sein kann, dass der Fahrzeugsitz das oben schon erläuterte Referenz-Objekt oder einen Teil des Referenz-Objektes bilden kann. Außerdem kann vorgesehen sein, dass das Sitzgestell zumindest teilweise die weiter oben erläuterte Referenz-Elektrode bilden kann. Zudem kann vorgesehen sein, dass das Lenkrad zumindest teilweise die Berühr-Oberfläche oder die Berühr-Oberfläche aufweisen kann, wie sie als Komponenten der Sensoranordnung weiter oben schon erläutert wurden. Darüber hinaus kann bei einer solchen Ausführungsvariante der Sensoranordnung vorgesehen sein, dass die unterhalb der Griffoberfläche und/oder dort integrierte flächige oder gewickelte leitfähige Schicht des Lenkrads die Berühr-Elektrode bildet oder die Berühr-Elektrode zumindest teilweise zur Verfügung stellt.

Die aus der Auswertung des veränderlichen Feldes oder der veränderlichen Feldparameter gewonnenen Informationen können zu unterschiedlichen Zwecken verwendet werden, unter anderem zur Steuerung und/oder zur Aktivierung oder Deaktivierung von Heizelementen im Fahrgastraum. Jedoch können die aus der Auswertung des veränderlichen Feldes oder der veränderlichen Feldparameter gewonnenen Informationen auch zu ganz anderen Zwecken verwendet werden, so etwa zur Steuerung von Komfort- oder Sicherheitsfunktionen im Kraftfahrzeug, zur Datengewinnung im Zusammenhang mit der Langzeitauswertung des Fahrzeugbenutzerverhaltens o. dgl. mehr.

Weiterhin wird zur Erreichung des oben genannten Ziels der Erfindung eine erste Ausführungsvariante eines Verfahrens zur Erfassung eines Verhaltens eines im Fahrgastraum in einem Kraftfahrzeug befindlichen Fahrzeugbenutzers vorgeschlagen, wobei sich der Fahrzeugbenutzer im Bereich eines Feldes aufhält oder zumindest teilweise durch seine Anwesenheit im Fahrgastraum in das Feld hineingelangt. Dieses Feld wird durch elektrisches Zusammenwirken einer im Bereich eines Referenz-Objektes befindlichen Referenz-Elektrode und einer im Bereich einer Berühr-Oberfläche angeordneten Berühr-Elektrode gebildet.

Bei dieser Verfahrensvariante ist die Berühr-Oberfläche beabstandet zum Referenz-Objekt angeordnet, und der Fahrzeugbenutzer beeinflusst durch Berühren der Berühr-Oberfläche oder durch eine Annäherung an die Berühr-Oberfläche mindestens einen physikalischen Parameter des Feldes. Mindestens einer dieser physikalischen Parameter kann eine Kapazität sein, die ein durch Referenz-Elektrode und Berühr-Elektrode gebildeter Kondensator hat. Mindestens einer dieser physikalischen Parameter kann wahlweise auch eine elektrische Induktivität sein, die eine zwischen der Referenz-Elektrode und der Berühr-Elektrode ausgebildete Bauteil-Induktivität hat.

Das Verfahren lässt sich am besten unter Verwendung einer Sensoranordnung durchführen, wie sie in zahlreichen unterschiedlichen Ausführungsvarianten weiter oben erläutert wurde. Alle diese Ausführungsvarianten sollen für die Durchführung des Verfahrens eingesetzt werden können, sofern sie sich hierfür eignen.

Weiterhin wird zur Erreichung des oben genannten Ziels der Erfindung eine weitere Ausführungsvariante des Verfahrens vorgeschlagen, das der Erfassung einer Sitzposition eines auf einem Fahrzeugsitz eines Kraftfahrzeuges befindlichen Fahrzeuglenkers und/oder der Handhaltung des Fahrzeuglenkers in Bezug auf ein in Fahrtrichtung vor dem Fahrzeugsitz befindliches und vom Fahrzeugsitz beabstandeten Lenkrad dient. Hierbei ist es erforderlich, dass der Fahrzeugsitz mit einem zumindest teilweise metallischen oder zumindest teilweise elektrisch leitfähigen Sitzgestell ausgestattet ist, und dass das Lenkrad mit einer unterhalb einer Griffoberfläche und/oder dort integrierten flächigen oder gewickelten leitfähigen Schicht ausgestattet ist.

Wie oben schon klarstellend erläutert, ist der Begriff des leitfähigen oder teilweise leitfähigen Sitzgestell sehr umfassend zu verstehen. Wie erwähnt, ist es für die Realisierbarkeit des hier erläuterten Verfahrens erforderlich, dass das Sitzgestell, auf dem der Fahrzeuglenker sitzt, eine zumindest teilweise metallische und damit zumindest teilweise elektrisch leitfähige Schicht aufweist, die insbesondere durch ein metallisches oder teilweise aus Metall bestehendes Sitzgestell gebildet sein kann. Diese Anordnung ist jedoch nicht die einzig mögliche oder sinnvolle, denn grundsätzlich können sich die leitfähigen Schichten auch im Sitzpolster, innerhalb der gepolsterten Sitzunterlage und/oder in der gepolsterten Sitzlehne befinden, so dass rein vorsorglich an dieser Stelle definiert sein soll, dass auch jegliche metallische und/oder leitfähige Schichten, die sich im Sitz- und/oder Lehnenpolster befinden und dort bspw. in Form von Rahmenteilen, von Federelementen und/oder von Sitzheizungsbestandteilen oder von metallischen oder elektrisch leitfähigen Heizleitern integriert sein können, als Sitzgestell im Sinne der Definition der vorliegenden Erfindung verstanden werden sollen.

Die hier beschriebene Ausführungsvariante des erfindungsgemäßen Verfahrens sieht außerdem vor, dass das Sitzgestell und/oder die leitfähige Schicht des Lenkrads jeweils voneinander getrennte, aber induktiv und/oder kapazitiv zusammenwirkende Spulen- oder Kondensatoranschlüsse bilden, so dass der auf dem Fahrzeugsitz befindliche und das Lenkrad mit seinen Händen umfassende Fahrzeuglenker in die Lage versetzt ist, eine messbare Kapazität und/oder Induktivität zu beeinflussen, die zwischen den als Kondensator- oder Spulenanschlüssen wirkenden Sitzgestell und Lenkrad ausgebildet wird. Diese veränderliche Kapazität und/oder Induktivität kann gemessen und zur Auswertung einer Sitzposition und/oder einer Handhaltung des Fahrzeuglenkers ausgewertet werden.

Alternativ oder zusätzlich kann bei dieser Verfahrensvariante vorgesehen sein, dass der auf dem Fahrzeugsitz befindliche und das Lenkrad mit seinen Händen umfassende Fahrzeuglenker oder Fahrzeugbenutzer ein Feld beeinflusst, das zwischen den als Elektroden wirkenden leitfähigen Schichten des Sitzgestells und des Lenkrades ausgebildet wird, wobei die durch die Sitzposition oder Veränderungen der Sitzposition des Fahrzeuglenkers oder Fahrzeugbenutzers verursachten Veränderungen des Feldes erfasst und ausgewertet werden können.

Wie dies ebenfalls weiter oben bereits erläutert wurde, kann das Lenkrad bei dieser Verfahrensvariante mit einer unterhalb seiner Griffoberfläche und/oder dort integrierten flächigen oder gewickelten leitfähigen Schicht ausgestattet sein, die bspw. ein flaches Heizelement ausbilden kann, die als elektrische Lenkradheizung fungiert.

Ein solches als Lenkradheizung eingesetztes Heizelement kann bspw. einen flächigen Träger mit einem strangförmigen oder gewendelt verlaufenden Heizleiter oder mit mehreren strangförmigen oder gewendelten Heizleitern umfassen, wobei die Heizleiter insbesondere durch dünne Stahllitzen gebildet sein können, da diese auch bei sehr kleinen Querschnitten einen definierten elektrischem Widerstand und dabei eine relativ hohe Heizleistung liefern können. Diese bspw. durch dünne Stahllitzen gebildeten Heizleiter können zudem vorteilhafterweise auf einem Träger aufgebracht sein, der vorzugsweise durch ein Vlies oder Gewirke gebildet ist. Der Heizleiter kann bei insbesondere auf den durch das Vlies oder Gewirke gebildeten Träger aufgenäht sein.

Darüber befindet sich normalerweise die Deckschicht des Lenkrades, die eine äußere Berührschicht oder Griffschicht bildet. Die Griffschicht kann bspw. durch eine Lederumhüllung oder durch eine dünne Kunststoffschicht gebildet sein.

Es muss an dieser Stelle nicht gesondert betont werden, dass jede der oben beschriebenen Ausführungsvarianten der erfindungsgemäßen Schaltungsanordnung geeignet sein kann zur Durchführung des Verfahrens. D.h. das erfindungsgemäße Verfahren kann normalerweise mit jeder der oben beschriebenen Varianten der Sensoranordnung durchgeführt werden, sofern sich die jeweils benutzten Wirkprinzipien - z.B. die Erfassung veränderlicherer Felder, veränderlicher Kapazitäten und/oder veränderlicher Induktivitäten - sowie die für das Verfahren eingesetzten Komponenten nicht gegenseitig ausschließen.

Darüber hinaus sei an dieser Stelle ausdrücklich erwähnt, dass alle Aspekte und Ausführungsvarianten, die im Zusammenhang mit der erfindungsgemäßen Sensoranordnung erläutert wurden, gleichermaßen Teilaspekte des erfindungsgemäßen Verfahrens betreffen oder bilden können. Wenn daher an einer Stelle bei der Beschreibung oder auch bei den Anspruchsdefinitionen zur erfindungsgemäßen Sensoranordnung von bestimmten Aspekten und/oder Zusammenhängen und/oder Wirkungen die Rede ist, so gilt dies gleichermaßen für das erfindungsgemäße Verfahren. In umgekehrter Weise gilt dasselbe, so dass auch alle Aspekte und Ausführungsvarianten, die im Zusammenhang mit dem erfindungsgemäßen Verfahren erläutert wurden, gleichermaßen Teilaspekte der erfindungsgemäßen Sensoranordnung betreffen oder sein können. Wenn daher an einer Stelle bei der Beschreibung oder auch bei den Anspruchsdefinitionen zum erfindungsgemäßen Verfahren von bestimmten Aspekten und/oder Zusammenhängen und/oder Wirkungen die Rede ist, so gilt dies gleichermaßen für die erfindungsgemäße Sensoranordnung.

Im Folgenden sollen Ausführungsbeispiele die Erfindung und ihre Vorteile anhand der beigefügten Figuren näher erläutern. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind.
Fig. 1 zeigt ein elektrisches Schaltbild, das ein Beispiel für eine Sensorschaltung liefert, die erkennen kann, ob ein Fahrzeuglenker mit seinen Händen das Lenkrad umfasst oder nicht.
Fig. 2 zeigt eine schematische Seitenansicht eines Fahrerplatzes eines Kraftfahrzeuges, mit einem auf einem Fahrzeugsitz befindlichen Fahrzeuglenker, der ein vor dem Fahrzeugsitz angeordnetes Lenkrad in Händen hält.
Fig. 3 zeigt eine Ausführungsvariante einer Sensoranordnung mit einigen ihrer zusammenwirkenden Komponenten.
Fig. 4A zeigt eine erste Ausführungsvariante einer Sensorschaltung, die auf der Messung einer veränderlichen Kapazität eines Kondensators beruht.
Fig. 4B zeigt eine zweite Ausführungsvariante einer Sensorschaltung, die auf der Messung einer veränderlichen Induktivität einer Spule beruht.
Fig. 4C zeigt eine dritte Ausführungsvariante einer Sensorschaltung, die auf der Messung der veränderlichen Induktivitäten zweier Spulen beruht.

Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die Erfindung ausgestaltet sein kann und stellen keine abschließende Begrenzung dar. Auch sind die nachfolgend beschriebenen Merkmale jeweils nicht in engem Zusammenhang mit weiteren Merkmalen des jeweiligen Ausführungsbeispiels zu verstehen, sondern können jeweils im allgemeinen Zusammenhang vorgesehen sein bzw. hierfür Verwendung finden.

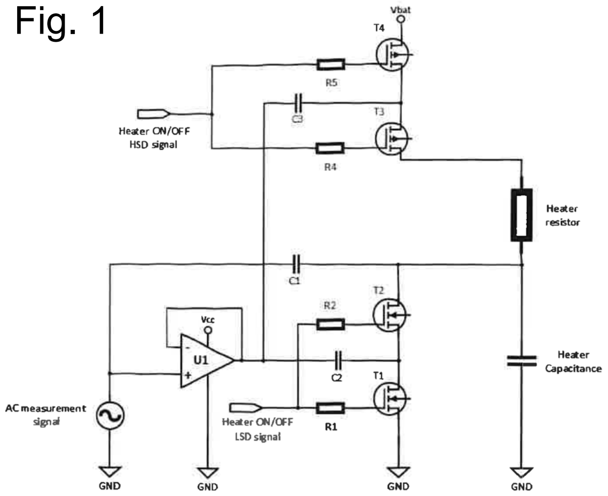

Das elektrische Schaltbild der Fig. 1 veranschaulicht den eine Ausführungsvariante einer Schaltung zur Unterdrückung oder Eliminierung von internen Kapazitäten eines Leistungs-MOSFET (Metall-Oxid-Halbleiter-Feldeffekttransistor), wenn ein Signal mit geringem Pegel auf einer Stromversorgungsleitung aufgeschaltet ist.

Als Schalter eingesetzte Leistungs-MOSFET bilden im geöffneten Zustand generell relativ hohe interne Kapazitäten zwischen dem Drain-Anschluss und dem Source-Anschluss aus, was im Wesentlichen an ihrer integrierten Diode liegt. Daraus folgt, dass diese Kapazität ungefähr umgekehrt proportional ist zu der zwischen dem Drain-Anschluss und dem Source-Anschluss anliegenden Spannung. Da sich diese Spannung verändern kann, ist es auch nicht möglich, einen festen Wert für die interne Kapazität anzugeben. Hinzu kommt, dass die interne Kapazität aus fertigungstechnischen Gründen unterschiedlich ausfallen kann, da verschiedene Chargen von hergestellten MOSFET jeweils leicht unterschiedliche Eigenschaften aufweisen können, so dass auch die Kapazitätswerte normalerweise streuen.

Da jedoch für manche Einsatzzwecke der Leistungs-MOSFET wie insbesondere den erwähnten Zweck, als Schaltelement zur Überlagerung von niedrigpegeligen Spannungen auf höhere Versorgungsspannungen zu dienen, diese internen Kapazitäten störende Einflüsse entwickeln können, wird mittels der in Fig. 1 vorgeschlagenen Schaltung versucht, diese negativen Einflüsse zu reduzieren oder zu eliminieren.

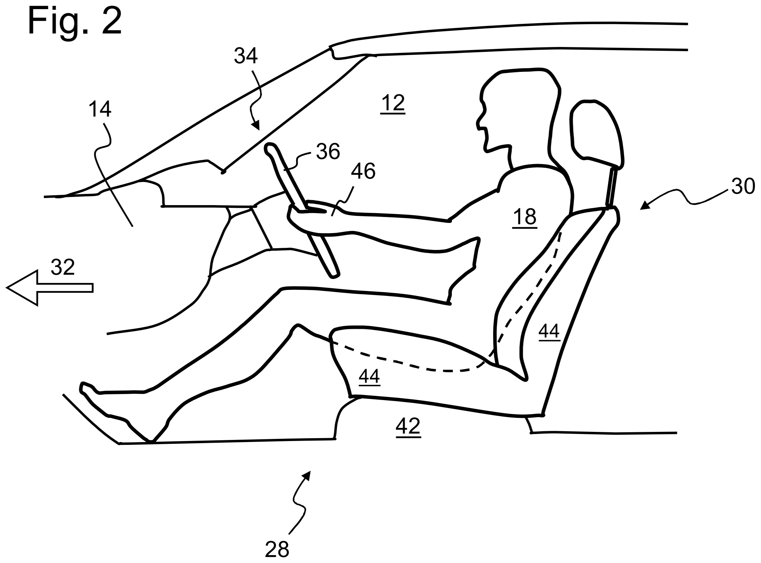

So verdeutlicht die elektrische Schaltung der Fig. 1 den oben erläuterten Anwendungsfall einer Detektionseinrichtung, die erkennen soll, ob ein Fahrzeuglenker 26 seine Hände 46 am Lenkrad 34 liegen oder von diesem entfernt hat. Die Energieversorgung für die elektrischen Heizelemente des Lenkrades 34 (vgl. Fig. 2) sollen dabei mittels der beiden unteren MOSFET T1 und T2, die jeweils vom n-Typ sind, und mittels der beiden oberen MOSFET T3 und T4, die jeweils vom p-Typ sind, geschaltet werden.

Hierbei sind die beiden n-Typ MOSFET T1 und T2 in einer Weise verschaltet, dass sie den Heizwiderstand (Heater resistor in Fig. 1) im Lenkrad 34 auf Masse schalten. Zudem sind die beiden p-Typ MOSFET T3 und T4 in einer Weise verschaltet, dass sie den Heizwiderstand mit der Stromversorgung (power supply; Vbat) verbinden können. Die unterhalb des Heizwiderstandes eingezeichnete Heizkapazität (Heater Capacitance) verdeutlicht die sich im Heizbetrieb einstellende Kapazität des Heizwiderstandes gegen den Masseanschluss (GND).

Bei geöffneten MOSFETs ist das niederpegelige Wechselstrom-Messsignal (AC measurement signal) über den Entkoppelungs-Kondensator C1 mit dem Heizwiderstand verbunden. Dieser Entkoppelungs-Kondensator C1 weist einen weitaus höheren Kapazitätswert auf als die Kapazität des Heizwiderstandes, um auf diese Weise einen Verlust an Signalstärke zu vermeiden.

Der Operationsverstärker U1 (unity gain amplifier U1), der das Signal mit dem Faktor "Eins" verstärkt und aufbereitet, sorgt dafür, das niederpegelige Wechselstrom-Messsignal (AC measurement signal) am Verbindungskontakt des MOSFET-Paares mit gleicher Phase und gleicher Amplitude einzuspeisen. Damit wird sichergestellt, dass die geöffneten MOSFET-Schalter noch nicht mit der Signalquelle beaufschlagt werden und solchermaßen die Messung beeinflussen können.

Die Kondensatoren C2 und C3 bilden jeweils Entkoppelungs-Kapazitäten und sorgen für eine Trennung unterschiedlicher Pegelspannungen der Gleichstromversorgung.

Da an den MOSFET T2 und T3 jeweils dasselbe Wechselspannungssignal an ihren Source- wie auch an ihren Drain-Anschlüssen anliegt, fließt durch T2 und T3 jeweils keine Wechselspannung, was auch dafür sorgt, dass die interne parasitäre Kapazität von T2 und T3 nicht die geschalteten Verbindungsleitungen erreicht.

Durch Messung der Amplitude und der Phase der Spannung und des Stroms des Messsignals ist es möglich, den Wert der Kapazität des Heizwiderstandes (Heater Capacitance of the Heater resistor) zu berechnen, was wiederum die gewünschten Informationen über den Berührstatus der Hände 46 des Fahrzeuglenkers 26 auf dem Lenkrad 34 liefern kann.

Darüber hinaus wären N-Kanal-MOSFETs ebenso als oberseitige Schalter verwendbar, womit eine Gate-Treiber-Schaltung realisierbar wäre.

Die schematische Seitenansicht der Fig. 2 zeigt eine Ausführungsvariante eines Fahrerplatzes 28 im Innenraum oder Fahrgastraum 12 des hier nicht vollständig, sondern nur ausschnittsweise gezeigten Kraftfahrzeuges 14, das in diesem Fall mit mindestens einem im Fahrgastraum 12 befindlichen Fahrzeugsitz 30 ausgestattet ist, auf dem sich der Fahrzeugbenutzer 26, d.h. bspw. ein Fahrzeuglenker in sitzender Position befindet. In Fahrtrichtung 32 vor dem Fahrzeugsitz 30 und beabstandet zu diesem befindet sich ein Lenkrad 34, dessen kreisrunder Lenkradkranz 36 vom Fahrzeugbenutzer 26 oder Fahrzeuglenker in Händen gehalten wird.

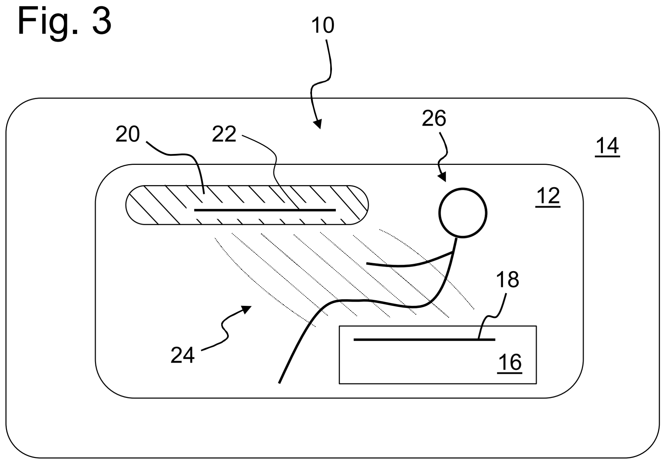

Der Fahrzeugsitz 30 kann insbesondere das Referenz-Objekt 16 gemäß Fig. 3 bilden, wobei leitfähige Bestandteile des Fahrzeugsitzes 30 die Referenz-Elektrode 18 bilden können. Außerdem kann das Lenkrad 34 die Berühr-Oberfläche 20 gemäß Fig. 3 bilden, während der normalerweise metallische und dadurch leitfähige Lenkradkranz 36 die Berühr-Elektrode 22 bilden kann. Dazwischen kann sich das Feld 24 (nur in Fig. 3 gezeigt) ausbilden. Die hier nicht mit einer Bezugsziffer gekennzeichnete Sensoranordnung 10 gemäß Fig. 3 nutzt die hier beschriebenen Komponenten.

Die Fig. 3 verdeutlicht die wesentlichen Komponenten einer Sensoranordnung 10 in einer stark schematisierten Darstellung, wobei die nachfolgende Beschreibung das Zusammenwirken dieser Komponenten erläutert, um die Sensoranordnung 10 in der gewünschten Weise einsetzen zu können.

Die nachfolgend näher erläuterte Sensoranordnung 10 befindet sich in einem Fahrgastraum 12, der Teil eines Kraftfahrzeuges 14 ist und sich innerhalb des Kraftfahrzeuges 14 befindet. Die Sensoranordnung 10 umfasst mindestens ein Referenz-Objekt 16, das sind innerhalb des Fahrgastraumes 12 befindet, sowie mindestens eine Referenz-Elektrode 18 im Bereich des Referenz-Objektes 16, d.h. bspw. in integrierter Bauweise oder als Teil des Referenz-Objektes 16. Beabstandet zum Referenz-Objekt 16 befindet sich eine Berühr-Oberfläche 20 sowie mindestens eine im Bereich der Berühr-Oberfläche 20 angeordnete Berühr-Elektrode 22, d.h. bspw. in integrierter Bauweise oder als Teil der Berühr-Oberfläche 20, dort eingebettet oder aufgebraucht.

Die Referenz-Elektrode 18 und die Berühr-Elektrode 22 wirken mittels eines Feldes 24 elektrisch zusammen, d.h. es kann zwischen den beiden Elektroden 18 und 22 ein elektrisches Feld 24 aufgebaut sein. Wahlweise kann das Feld auch ein magnetisches oder elektromagnetisches Feld sein, was aber hier nicht näher erläutert sein soll. Ein Fahrzeugbenutzer 26, der sich innerhalb des Fahrgastraumes 12 des Kraftfahrzeuges 14 befindet, kann durch Berühren der Berühr-Oberfläche 20 oder bereits durch eine Annäherung an die Berühr-Oberfläche 20 mindestens einen physikalischen Parameter des Feldes 24 beeinflussen.

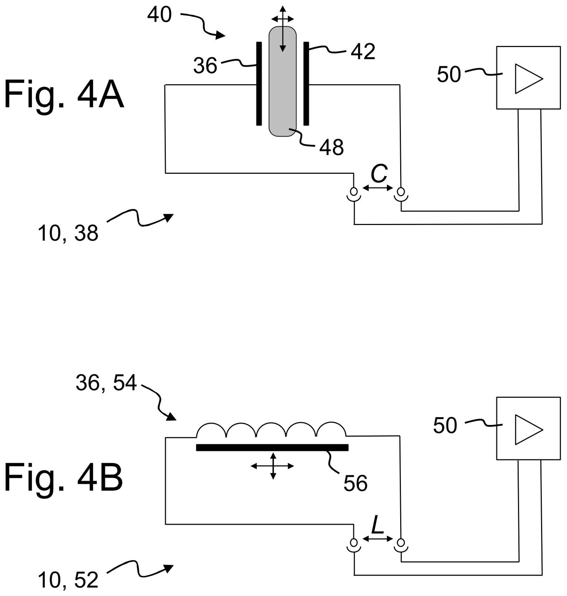

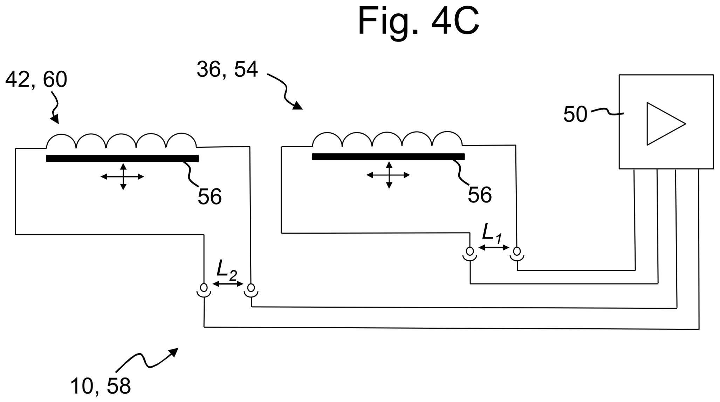

Wie es im Folgenden näher erläutert werden wird, kann der mindestens eine physikalische Parameter des Feldes 24 entweder eine Kapazität C (vgl. Fig. 4A), eine elektrische Induktivität (vgl. Fig. 4B und/oder Fig. 4C) oder eine Kombination einer überlagerten Kapazität und Induktivität sein.

Das stark vereinfachte elektrische Schaltbild der Fig. 4A veranschaulicht eine erste Ausführungsvariante einer Sensorschaltung 38, die auf der Messung einer veränderlichen Kapazität C eines Kondensators 40 beruht. Die hier gezeigte Sensorschaltung 38 kann insbesondere Teil einer Sensoranordnung 10 gemäß Fig. 3 oder auch nur einen Teilaspekt der Sensoranordnung zeigen, nämlich die Messung eines veränderlichen Parameters des Feldes 24 gemäß Fig. 3, wobei dieser Parameter durch die Kapazität C gebildet ist oder diese Kapazität C umfasst, deren Ersatzschaltbild in Fig. 4A verdeutlicht ist.

Um die hier vorgeschlagene Sensorschaltung 38 gemäß der vereinfachten Darstellung der Fig. 4A realisieren zu können, kann der gezeigte Fahrzeugsitz 30 über ein zumindest teilweise metallisches und damit auch über ein zumindest teilweise elektrisch leitfähiges Sitzgestell 42 verfügen, wobei ein solches leitfähiges Sitzgestell 42 wahlweise auch durch leitfähige Schichten im Sitzpolster 44, d.h. in der gepolsterten Sitzunterlage und/oder in der gepolsterten Sitzlehne gebildet sein kann. Solche metallischen und/oder leitfähigen Schichten können sich somit im Sitz- und/oder Lehnenpolster 44 befinden und dort bspw. in Form von Rahmenteilen, von Federelementen und/oder von Sitzheizungsbestandteilen integriert sein können, was allesamt als im Sitzgestell 42 befindlich oder durch das Sitzgestell 42 realisiert im Sinne der Definition der vorliegenden Erfindung subsumiert sein soll.

Wie oben erläutert, können somit diese leitfähigen Bestandteile im Sitzgestell 42 und/oder im Sitz- bzw. Lehnenpolster 44 die Referenz-Elektrode 18 der Sensoranordnung 10 bilden.

Außerdem ist es für die Realisierung der Sensorschaltung 38 notwendig, dass auch das Lenkrad 34 mit einer unterhalb einer Griffoberfläche des Lenkradkranzes 36 und/oder dort integrierten flächigen oder gewickelten leitfähigen Schicht ausgestattet ist, die bspw. ein flaches Heizelement ausbilden kann, die eine elektrische Lenkradheizung bildet. Diese elektrische Lenkradheizung basiert auf dem Prinzip eines stromdurchflossenen elektrischen Widerstandes, der sich aufgrund des Stromflusses erwärmt, was vom Fahrzeuglenker 26 als lokale Erwärmung beim Umfassen des Lenkradkranzes 36 mit seinen Händen 46 (vgl. Fig. 2) wahrgenommen wird.

Die konkrete Ausgestaltung des Heizelementes im Lenkradkranz 36 soll an dieser Stelle nicht interessieren, da es für die Funktionsweise der erfindungsgemäßen Sensorschaltung 26 in erster Linie wichtig ist, dass ein metallischer oder elektrisch leitfähiger Leiter vorhanden ist, der bspw. durch mehrere strangförmig oder gewendelt verlaufende dünne Stahllitzen gebildet sein kann. Dieser Leiter kann insbesondere die Berühr-Elektrode 22 (vgl. Fig. 3) bilden. Darüber befindet sich normalerweise die Deckschicht des Lenkradkranzes 36, die als äußere Berührschicht oder Griffschicht vorzugsweise eine haptisch angenehme Oberfläche aufweist und deshalb insbesondere durch eine Lederschicht gebildet sein kann. Diese Griffschicht des Lenkradkranzes 36 bildet somit die Berühr-Oberfläche 20 (vgl. Fig. 3).

Wie es die Fig. 4A beispielhaft erkennen lässt, können das Sitzgestell 42 bzw. die mit leitfähiger Schicht ausgestatteten Sitz- und/oder Lehnenpolster 44 sowie die leitfähige Schicht der Lenkradheizung im Lenkradkranz 36 jeweils voneinander getrennte, aber kapazitiv zusammenwirkende Kondensatoranschlüsse bilden, wenn die Kapazität C des Feldes 24 mit dem Kondensator 40 als Ersatzschaltbild gesehen wird. Die linke Kondensatorplatte des in Fig. 4A schematisch gezeigten Kondensators 40 ist mit der Bezugsziffer 36 bezeichnet, da sie durch den im Lenkradkranz 36 des Lenkrades 34 befindlichen leitfähigen Heizleiter gebildet ist. Die rechte Kondensatorplatte ist demzufolge mit der Bezugsziffer 42 bezeichnet, da sie durch das leitfähige oder mit leitfähiger Schicht ausgestattete Sitzgestell 42 des Fahrzeugsitzes 30 gebildet ist.

Außerdem lässt der in Fig. 4A gezeigte Kondensator 40 ein zwischen den beiden Platten 36 und 42 befindliches Dielektrikum 48 erkennen, das durch den Fahrzeuglenker 26 selbst gebildet sein kann, bzw. welches Dielektrikum 48 den feldbeeinflussenden Parameter des Feldes 24 repräsentieren kann. Die Sensorschaltung 38 kann somit im Wesentlichen dadurch realisiert sein, dass die leitfähige Schicht des Lenkradkranzes 36 sowie das zumindest teilweise elektrisch leitfähige Sitzgestell 42 zwei voneinander beabstandete Elektroden des Kondensators 40 ausbilden, so dass der auf dem Fahrzeugsitz 30 befindliche und das Lenkrad 34 mit seinen Händen 46 umfassende Fahrzeuglenker 26 ein zwischen den beabstandeten Elektroden 36, 42 des Kondensators 40 befindliches und veränderliches Dielektrikum 48 bildet, das die messbare Kapazität C des Kondensators 40 verändert.

Auf diese Weise kann die durch die Sitzposition und/oder Handhaltung des auf dem Fahrzeugsitz 30 befindlichen Fahrzeuglenkers 26 beeinflusste Kapazität C aufgrund des vom Fahrer 26 gebildeten und veränderlichen Dielektrikums 48 des Kondensators 40 gemessen und mittels einer Auswerteschaltung 50 verarbeitet werden.

Die Veränderlichkeit und Beeinflussbarkeit des Dielektrikums 48, die durch die variabel positionierbaren Hände 46 und/oder den auf dem Sitz- und Lehnenpolster 44 befindlichen und dort beweglich bleibenden Fahrer 26 gegeben ist, wird in der Darstellung der Fig. 4A durch den am Dielektrikum 48 eingezeichneten Doppelpfeil mit zueinander senkrechten Pfeilrichtungen angedeutet, da das Dielektrikum 48 definitionsgemäß einerseits innerhalb der Elektroden 36 und 42 des Kondensators 40 hin und her geschoben werden kann als auch durch die variable Statur und die unterschiedlichen elektrischen Eigenschaften verschiedener Personen als Fahrer 26 in seiner virtuell zu verstehenden Dimension veränderlich ist.

Was aus der Darstellung der Fig. 4A nicht deutlich hervorgeht, ist der Aspekt der Energieversorgung des Heizleiters der Lenkradheizung, der sich nicht ohne Weiteres die Signalwerte für den durch die Elektroden 36 und 42 mit dazwischen befindlichem Dielektrikum 48 gebildeten Kondensator 40 aufprägen oder überlagern lassen. So benötigt der Kondensator 40 für eine Messung seiner veränderlichen Kapazität C einen den Kondensator 40 durchfließenden Wechselstrom, der aber normalerweise für eine Lenkradheizung nicht zur Verfügung steht, denn diese wird mit Gleichspannung des Bordnetzes des Kraftfahrzeugs betrieben. Deshalb ist es für die Realisierung einer solch konkreten Sensorik 38 entsprechend Fig. 4A sinnvoll, der Versorgungsspannung für die Lenkradheizung ein hochfrequentes Wechselspannungssignal zu überlagern. Diese Signale können mittels der Auswerteschaltung 50 erfasst und ausgewertet werden, wodurch sich auch der elektrische Heizbetrieb und der Betrieb der Sensorschaltung 38 nicht nennenswert gegenseitig stören.

Da es sich bei der in Fig. 4A schematisch dargestellten Sensorik 38 jedoch auch um ein Ersatzschaltbild der Sensoranordnung 10 gemäß Fig. 3 handeln kann, spielen diese energetischen Aspekte keine Rolle, da die Elektroden 36 und 42 die oben genannten Referenz-Elektroden 18 und Berühr-Elektroden 22 lediglich repräsentieren sollen, während das Dielektrikum 48 das mit veränderlichen Parametern zwischen den Elektroden 18 und 22 ausgebildete Feld 24 repräsentieren kann, dessen Feldeigenschaften gemessen werden. Hierfür steht repräsentativ die Auswerteschaltung 50.

Das stark vereinfachte elektrische Schaltbild der Fig. 4B zeigt eine zweite Ausführungsvariante einer Sensorschaltung 52, die auf der Messung einer veränderlichen Induktivität L einer Spule 54 beruht. Auch die Sensorschaltung 52 gemäß Fig. 4B beruht wiederum auf der bereits oben unter Bezugnahme auf die Fig. 2 erläuterten Anordnung von Fahrzeugsitz 30, darauf befindlichem Fahrzeuglenker 26 und vor dem Fahrzeugsitz 30 befindlichem Lenkrad 34, dessen Lenkradkranz 36 vom Fahrzeuglenker 26 mit seinen Händen 46 ergriffen werden kann.

Für die Realisierung der Sensorschaltung 52 gemäß Fig. 4B ist es zumindest notwendig, dass das in Fig. 2 in Seitenansicht gezeigte Lenkrad 34 mit einer unterhalb einer Griffoberfläche des Lenkradkranzes 36 und/oder dort integrierten flächigen oder gewickelten leitfähigen Schicht ausgestattet ist, die bspw. ein flaches Heizelement ausbilden kann, die eine elektrische Lenkradheizung bildet.

Wie es die Fig. 4B beispielhaft erkennen lässt, kann die leitfähige Schicht der Lenkradheizung im Lenkradkranz 36 eine Spule 54 ausbilden, was insbesondere dann gegeben sein kann, wenn die Heizleitung spulenförmig um den Lenkradkranz 36 gewickelt ist (hier nicht gezeigt). Das leitfähige Sitzgestell 42 ist im Zusammenhang mit dieser vereinfachten zweiten Ausführungsvariante dagegen kein zwingend notwendiger Bestandteil der Sensorschaltung 52. Aus diesem Grund ist dort das Sitzgestell 42 auch nicht gekennzeichnet und keine entsprechende Bezugsziffer eingezeichnet.

Der Spule 54 ist ein veränderlicher und beweglicher Spulenkern 56 zugeordnet, der durch den Fahrzeuglenker 26 selbst gebildet sein kann. Die hier gezeigte zweite Variante der Sensorschaltung 52 wird somit im Wesentlichen dadurch realisiert, dass die leitfähige Schicht des Lenkradkranzes 36 eine Spule 54 ausbildet, wobei der auf dem Fahrzeugsitz 30 befindliche und das Lenkrad 34 mit seinen Händen 46 umfassende Fahrzeuglenker 26 den veränderlichen Spulenkern 56 bildet, wodurch auch die messbare Induktivität L der Spule 54 verändert wird.

Auf diese Weise kann die durch die Sitzposition und/oder Handhaltung des auf dem Fahrzeugsitz 30 befindlichen Fahrzeuglenkers 26 beeinflusste Induktivität L aufgrund des vom Fahrer 26 gebildeten und veränderlichen Spulenkerns 56 der Spule 54 gemessen und mittels der Auswerteschaltung 50 verarbeitet werden.

Die Veränderlichkeit und Beeinflussbarkeit des Spulenkerns 56, die durch die variabel positionierbaren Hände 46 und/oder den auf dem Sitz- und Lehnenpolster 44 befindlichen und dort beweglich bleibenden Fahrer 26 und dessen variabler Sitzhaltung gegeben ist, wird in der Darstellung der Fig. 4B durch den am Spulenkern 56 eingezeichneten Doppelpfeil mit zueinander senkrechten Pfeilrichtungen angedeutet, da der Spulenkern 56 definitionsgemäß einerseits in unmittelbarer Nähe der im Lenkradkranz 36 befindlichen Spule 54 hin und her bewegt werden kann, als auch durch die variable Statur und die unterschiedlichen elektrischen Eigenschaften verschiedener Personen als Fahrer 26 in seiner virtuell zu verstehenden Dimension veränderlich ist.

Was aus der Darstellung der Fig. 4B wiederum nicht deutlich hervorgeht, ist der Aspekt der Energieversorgung des Heizleiters der Lenkradheizung, der sich nicht ohne Weiteres die Signalwerte für die Spule 54 aufprägen oder überlagern lassen. So benötigt die Spule 54 für eine Messung ihrer veränderlichen Induktivität L einen die Spule 54 durchfließenden Wechselstrom, der aber normalerweise für eine Lenkradheizung nicht zur Verfügung steht, denn diese wird mit Gleichspannung des Bordnetzes des Kraftfahrzeugs 14 betrieben. Deshalb ist es für die Realisierung der gewünschten Sensorik 52 wiederum sinnvoll, der Versorgungsspannung für die Lenkradheizung ein hochfrequentes Wechselspannungssignal zu überlagern. Diese Signale können mittels der Auswerteschaltung 50 erfasst und ausgewertet werden, wodurch sich auch der elektrische Heizbetrieb und der Betrieb der Sensorschaltung 52 nicht nennenswert gegenseitig stören.

Da es sich bei der in Fig. 4B schematisch dargestellten Sensorik 52 jedoch ebenfalls um ein Ersatzschaltbild der Sensoranordnung 10 gemäß Fig. 3 handeln kann, spielen diese energetischen Aspekte keine Rolle, da die Spule 54 auch als Ersatzschaltbild für das Feld 24 betrachtet werden kann, wobei der Spulenkern 56 die veränderlichen Feldparameter repräsentiert, die in diesem Fall als Induktivität L betrachtet werden können. Die Referenz-Elektroden 18 und Berühr-Elektroden 22, die für die Sensoranordnung 10 notwendig sind, finden bei dieser Betrachtung in Fig. 4B keine eindeutigen Entsprechungen, während aber die durch den Spulenkern 56 repräsentierten Feldeigenschaften gemessen werden können. Hierfür steht repräsentativ die Auswerteschaltung 50.

Das stark vereinfachte elektrische Schaltbild der Fig. 4C zeigt eine dritte Ausführungsvariante einer Sensorschaltung 58, die auf der Messung der veränderlichen Induktivitäten L₁ und L₂ zweier Spulen 54 und 60 beruht. Auch die Sensorschaltung 58 gemäß Fig. 4C beruht wiederum auf der bereits oben unter Bezugnahme auf die Fig. 2 erläuterten Anordnung von Fahrzeugsitz 30, darauf befindlichem Fahrzeuglenker 26 und vor dem Fahrzeugsitz 30 befindlichem Lenkrad 34, dessen Lenkradkranz 36 vom Fahrzeuglenker 26 mit seinen Händen 46 ergriffen werden kann.

Für die Realisierung der Sensorschaltung 58 gemäß Fig. 4C ist es zumindest notwendig, dass das in Fig. 2 in Seitenansicht gezeigte Lenkrad 34 mit einer unterhalb einer Griffoberfläche des Lenkradkranzes 36 und/oder dort integrierten flächigen oder gewickelten leitfähigen Schicht ausgestattet ist, die bspw. ein flaches Heizelement ausbilden kann, die eine elektrische Lenkradheizung bildet. Die leitfähige Schicht der Lenkradheizung im Lenkradkranz 36 kann die bereits oben anhand der Fig. 4B erläuterte erste Spule 54 ausbilden, was insbesondere dann gegeben sein kann, wenn die Heizleitung spulenförmig um den Lenkradkranz 36 gewickelt ist (hier nicht gezeigt).

Außerdem bildet das leitfähige Sitzgestell 42 des Fahrzeugsitzes 30 oder die im Sitz- oder Lehnenpolster 44 angeordnete leitfähige Schicht (z.B. Sitzheizung) eine zweite Spule 60 aus, die hier neben die erste Spule 54, aber getrennt von dieser gezeichnet ist.

Beiden Spulen 54 und 60 ist jeweils ein veränderlicher und beweglicher Spulenkern 56 zugeordnet, der durch den Fahrzeuglenker 26 selbst gebildet ist. Insbesondere kann der Spulenkern 56 der ersten Spule 54 durch die auf dem Lenkradkranz 36 liegenden Hände 46 des Fahrzeuglenkers 26 gebildet sein, während der Spulenkern 56 der zweiten Spule 60 im Wesentlichen durch den auf dem Fahrzeugsitz 30 befindlichen Körper des Fahrers 26 gebildet sein kann. Die in Fig. 4C separat dargestellten Spulenkerne 56 können wahlweise auch als ein einziger Spulenkern 56, gebildet durch den Fahrzeuglenker 26, betrachtet werden.

Die hier gezeigte dritte Variante der Sensorschaltung 58 wird somit im Wesentlichen dadurch realisiert, dass die leitfähige Schicht des Lenkradkranzes 36 die erste Spule 54 ausbildet, wobei der auf dem Fahrzeugsitz 30 befindliche und das Lenkrad 34 mit seinen Händen 46 umfassende Fahrzeuglenker 26 den veränderlichen Spulenkern 56 bildet, wodurch auch die messbare Induktivität L₁ der ersten Spule 54 verändert wird. Außerdem wird ein Bestandteil der dritten Sensorschaltung 58 dadurch gebildet, dass der auf dem Fahrzeugsitz 30 befindliche Fahrzeuglenker 26 auch den veränderlichen Spulenkern 56 der zweiten Spule 60 darstellt, wodurch auch die messbare Induktivität L₂ der zweiten Spule 60 verändert wird.

Auf diese Weise können die durch die Sitzposition und/oder Handhaltung des auf dem Fahrzeugsitz 30 befindlichen Fahrzeuglenkers 26 beeinflussten Induktivitäten L₁ und L₂ aufgrund der vom Fahrer 26 gebildeten und veränderlichen Spulenkerne 56 der beiden Spulen 54 und 60 gemessen und mittels der Auswerteschaltung 50 verarbeitet werden.

Die Veränderlichkeit und Beeinflussbarkeit der Spulenkerne 56, die durch die variabel positionierbaren Hände 46 und/oder den auf dem Sitz- und Lehnenpolster 44 befindlichen und dort beweglich bleibenden Fahrer 26 gegeben ist, wird in der Darstellung der Fig. 4C durch die jeweils an den Spulenkernen 56 eingezeichneten Doppelpfeile mit zueinander senkrechten Pfeilrichtungen angedeutet, da die Spulenkerne 56 definitionsgemäß einerseits in unmittelbarer Nähe der im Lenkradkranz 36 befindlichen ersten Spule 54 und durch die im Sitzgestell 42 befindlichen zweiten Spule 60 hin und her bewegt werden kann als auch durch die variable Statur und die unterschiedlichen elektrischen Eigenschaften verschiedener Personen als Fahrer 26 in seiner virtuell zu verstehenden Dimension veränderlich ist.

Was aus der Darstellung der Fig. 4C wiederum nicht deutlich hervorgeht, ist der Aspekt der Energieversorgung des Heizleiters der Lenkradheizung, der sich nicht ohne Weiteres die Signalwerte für die Spulen 54 und 60 aufprägen oder überlagern lassen. So benötigen die Spulen 54 und 60 für eine Messung ihrer veränderlichen Induktivitäten L₁ und L₂ einen die Spulen 54 und 60 jeweils durchfließenden Wechselstrom, der aber normalerweise für eine Lenkradheizung nicht zur Verfügung steht, denn diese wird mit Gleichspannung des Bordnetzes des Kraftfahrzeugs betrieben. Deshalb ist es für die Realisierung der gewünschten Sensorik 58 wiederum sinnvoll, der Versorgungsspannung für die Lenkradheizung ein hochfrequentes Wechselspannungssignal zu überlagern. Diese Signale können mittels der Auswerteschaltung 50 erfasst und ausgewertet werden, wodurch sich auch der elektrische Heizbetrieb und der Betrieb der Sensorschaltung 58 nicht nennenswert gegenseitig stören.

Da es sich auch bei der in Fig. 4C schematisch dargestellten Sensorik 58 wiederum um ein Ersatzschaltbild der Sensoranordnung 10 gemäß Fig. 3 handeln kann, müssen solche energetischen Aspekte keine Rolle spielen, da die beiden Spule 54 und 60 wahlweise auch als Ersatzschaltbild für das Feld 24 betrachtet werden können, wobei der Spulenkern 56 oder die beiden Spulenkerne 56 die veränderlichen Feldparameter repräsentieren können, die in diesem Fall als Induktivitäten L₁ und L₂ betrachtet werden können. Die Referenz-Elektroden 18 und Berühr-Elektroden 22, die für die Sensoranordnung 10 notwendig sind, finden bei dieser Betrachtung in Fig. 4C ihre Entsprechungen in den beiden Spulen 54 und 60, so dass die durch den Spulenkern 56 repräsentierten Feldeigenschaften gemessen werden können. Hierfür kann wiederum die Auswerteschaltung 50 als repräsentativ betrachtet werden.

Es sei an dieser Stelle darauf hingewiesen, dass Teile von Oberflächen und/oder vom Fahrzeugbenutzer 26 erreichbare Flächen oder Gegenstände innerhalb des Fahrgastraumes 12 beheizbar sind (vgl. Fig. 3 und/oder Fig. 2). Da solche beheizten oder beheizbaren Berühr-Oberflächen 20, die bspw. an hier nicht gezeigten seitlichen Innenverkleidungen, am Dachhimmel oder auch am Lenkrad 34 im Fahrgastraum 12 angeordnet sein können, insbesondere durch leistungsfähige Strahlungsheizungen innerhalb des Fahrgastraums 12 realisiert sein können, sind geeignete Maßnahmen zu treffen, um die Fahrzeugbenutzer 26 vor Beeinträchtigungen solcher Strahlungsheizungen zu schützen. Da die beheizten Oberflächen solcher Strahlungsheizungen auf Temperaturen von teilweise über 100°C aufgeheizt werden, um ein gewünschtes Ausmaß an Strahlungswärme erzeugen zu können, müssen die hohen Temperaturen möglichst verzögerungsfrei abgeschaltet werden, sobald sich ein Fahrzeugbenutzer 26 einer dieser Heiz- und Heißzonen annähert oder die betreffende Berühr-Oberfläche 20 kontaktiert.

Es ist deshalb sinnvoll, zumindest diejenigen Bereiche im Fahrgastraum 12 mit Komponenten der hierfür relevanten Sensorik 38, 52 und/oder 58 der erfindungsgemäßen Sensoranordnung 10 auszustatten, die mit solchen beheizten Flächen oder InfrarotStrahlern ausgestattet sind, so dass vorzugsweise jedem ggf. vorhandenen Heizelement oder Infrarot-Strahler eine in unmittelbarer räumlicher Nähe befindliche bzw. in der beheizbaren oder beheizten Berühr-Oberfläche 20 integrierte Berühr-Elektrode 22 zugeordnet ist. Da mehrere Heizelemente oder Infrarot-Strahler im Fahrgastraum 12 verteilt sein können, muss zumindest die Oberflächentemperatur desjenigen Heizelements oder Infrarot-Strahlers verzögerungsfrei auf gesundheitlich unbedenkliche Werte reduziert werden können, dem sich der Fahrzeugbenutzer 26 oder dem sich einer von mehreren Fahrzeugbenutzern 26 nähert oder es kontaktiert.

Die Erfindung wurde unter Bezugnahme auf eine bevorzugte Ausführungsform beschrieben. Es ist jedoch für einen Fachmann vorstellbar, dass Abwandlungen oder Änderungen der Erfindung gemacht werden können, ohne dabei den Schutzbereich der nachstehenden Ansprüche zu verlassen.

### Bezugszeichenliste

- 10: Sensoranordnung
- 12: Fahrgastraum, Innenraum
- 14: Kraftfahrzeug
- 16: Referenz-Objekt
- 18: Referenz-Elektrode
- 20: Berühr-Oberfläche
- 22: Berühr-Elektrode
- 24: Feld
- 26: Fahrzeugbenutzer, Fahrer, Fahrzeuglenker
- 28: Fahrerplatz
- 30: Fahrzeugsitz
- 32: Fahrtrichtung
- 34: Lenkrad
- 36: Lenkradkranz
- 38: Sensorschaltung, erste Sensorschaltung
- 40: Kondensator
- 42: Sitzgestell
- 44: Sitzpolster, Lehnenpolster
- 46: Hand, Hände
- 48: Dielektrikum
- 50: Auswerteschaltung
- 52: Sensorschaltung, zweite Sensorschaltung
- 54: Spule, erste Spule
- 56: Spulenkern
- 58: Sensorschaltung, dritte Sensorschaltung
- 60: Spule, zweite Spule

- Vbat: Energieversorgung
- Heater resistor: Heizwiderstand
- T1: MOSFET n-Typ
- T2: MOSFET n-Typ
- T3: MOSFET p-Typ
- T4: MOSFET p-Typ
- GND: Masseanschluss
- Heating capacitance: Heizkapazität
- C1: Entkopplungs-Kondensator
- C2, C3: Kondensatoren
- U1: Operationsverstärker
- AC measurement signal: Niederpegeliges Wechselstrom-Messsignal
- U1: Operationsverstärker

## Patentansprüche

1. Schaltung für eine Sensoranordnung (10) in einem Fahrgastraums (12) eines Kraftfahrzeugs (14) zur Unterdrückung oder Eliminierung von internen Kapazitäten eines Leistungs-MOSFETS wenn ein Signal mit niederpegeligen Wechselstrom Messsignal auf die Energieversorgung für die elektrischen Heizelemente aufgeschaltet ist, umfassend
- eine Energieversorgung (Vbat) für elektrische Heizelemente im Lenkrad (34), umfassend einen Heizwiderstand (Heater resistor),
- MOSFET T1 und T2, wobei T1 und T2 jeweils vom n-Typ sind,
- MOSFET T3 und T4, wobei T3 und T4 jeweils vom p-Typ sind,
- einen Masseanschluss (GND),
- eine Heizkapazität (Heating capacitance),
- einen Entkopplungs-Kondensator (C1),
- Kondensatoren (C2 und C3),
- einen Operationsverstärker (U1), und
- ein niederpegeliges Wechselstrom-Messsignal (AC measurement signal),
**dadurch gekennzeichnet, dass** die Energieversorgung für die elektrischen Heizelemente des Lenkrades (34) mittels der MOSFET T1 und T2 und MOSFET T3 und T4 verschaltet sind, wobei MOSFET T1 und T2 den Heizwiderstand (Heater resistance) im Lenkrad (34) auf Masse schalten und MOSFET T3 und T4 den Heizwiderstand (Heater resistance) mit der Stromversorgung (Vbat) verbinden.

2. Schaltung nach Anspruch 1, bei welcher die Heizkapazität (Heating capacitance) die sich im Heizbetrieb einstellende Kapazität des Heizwiderstandes gegen den Masseanschluss (GND) ist.

3. Schaltung nach Anspruch 1 oder 2, bei welcher das niederpegelige Wechselstrom-Messsignal (AC measurement signal) über den Entkopplungs-Kondensator (C1) mit dem Heizwiderstand (Heater resistor) verbunden ist und wobei der Entkopplungs-Kondensator (C1) einen höheren Kapazitätswert als die Kapazität des Heizwiderstandes (Heater resistor) aufweist.

4. Schaltung nach einem der vorhergehenden Ansprüche, bei welcher der Operationsverstärker (U1) das niederpegelige Wechselstrom-Messsignal (AC measurment signal) mit dem Faktor "Eins" verstärkt und aufbereitet und am Verbindungskontakt der MOSFET T1, T2 und MOSFET T3 und T4 mit gleicher Phase und gleicher Amplitude einspeist.

5. Schaltung nach einem der vorhergehenden Ansprüche, bei welcher die Kondensatoren (C2, C3) jeweils Entkopplungs-Kapazitäten bilden und für eine Trennung unterschiedlicher Pegelspannungen der Gleichstromversorgung sorgen, wobei an MOSFET T2 und T3 dasselbe Wechselspannungssignal anliegt.

6. Schaltung nach einem der vorhergehenden Ansprüche, bei welcher durch eine Messung der Amplitude und der Phase der Stromspannung des Messsignals die Kapazität des Heizwiderstandes (Heating capacitance of the Heater resistor) berechnet wird.

7. Schaltung nach Anspruch 6, bei welcher der berechnete Wert der Kapazität des Heizwiderstandes Informationen über den Berührstatus der Hände des Fahrzeuglenkers auf dem Lenkrad liefert.
